(19) Europäisches Patentamt
European Patent Office
Office européen des brevets

(11) **EP 2 264 718 B1**

(12) **EUROPEAN PATENT SPECIFICATION**

(45) Date of publication and mention
of the grant of the patent:
**01.01.2014 Bulletin 2014/01**

(51) Int Cl.:
**H01L 39/24** *(2006.01)*

(21) Application number: **10182495.1**

(22) Date of filing: **04.08.2004**

(54) **Method for producing oxide superconducting wire material**

HERSTELLUNGSVERFAHREN FÜR OXIDSUPRALEITENDES DRAHTMATERIAL

PROCEDE DE PRODUCTION ET DE MODIFICATION D'UN FIL D'OXYDE SUPRACONDUCTEUR

(84) Designated Contracting States:
**DE DK FR GB IT**

(30) Priority: **28.08.2003 JP 2003304536**

(43) Date of publication of application:
**22.12.2010 Bulletin 2010/51**

(62) Document number(s) of the earlier application(s) in
accordance with Art. 76 EPC:
**04771174.2 / 1 659 595**

(73) Proprietor: **Sumitomo Electric Industries, Ltd.
Osaka-shi,
Osaka 541-0041 (JP)**

(72) Inventors:
• **Kobayashi, S.
Osaka 5548511 (JP)**
• **Kato, T.
Osaka 5548511 (JP)**
• **Yamazaki, K.
Osaka 5548511 (JP)**

(74) Representative: **Kreutzer, Ulrich
Cabinet Beau de Loménie
Lessingstrasse 6
80336 München (DE)**

(56) References cited:
**WO-A-01/22436     US-A- 6 069 116**

**Description**

Technical Field

The present invention relates to a method of manufacturing an oxide superconducting wire, and more particularly, it relates to a method of manufacturing an oxide superconducting wire capable of improving the critical current density.

Background Art

In general, a method of obtaining an oxide superconducting wire by heat-treating a wire formed by charging a metal tube with raw material powder of an oxide superconductor and thereafter wiredrawing and rolling the metal tube for sintering the raw material powder of the oxide superconductor is known as a method of manufacturing an oxide superconducting wire. However, the wire is blistered in the aforementioned heat treatment step for sintering, to disadvantageously reduce the superconductivity of the obtained oxide superconducting wire.

Japanese Patent Laying-Open No. 5-101723 (Patent Document 1) proposes a method of manufacturing an oxide superconducting wire by heat-treating a metal tube filled with powder of an oxide superconductor or a flattened body thereof in a pressurized atmosphere for sintering the powder of the oxide superconductor. The aforementioned gazette describes that a wire having excellent superconductivity is obtained according to this method by performing a pressure heat treatment.

More specifically, it is attempted to store a metal tube charged with powder of an oxide superconductor in a heat-resistant/pressure-resistant closed vessel for preventing blistering in sintering by increasing the internal pressure following heat-up in the closed vessel. The aforementioned gazette describes that the current internal pressure can be obtained from a state equation of gas or the like, and an internal pressure of about 4 atm. can be obtained with a heating temperature of about 900°C, for example.

Japanese Patent No. 2592846 (Japanese Patent Laying-Open No. 1-30114) (Patent Document 2) proposes a method of manufacturing an oxide superconducting conductor by holding a metal tube filled with oxide superconducting powder or the like in a high-pressure state at least either in a heat treatment or after the heat treatment. The aforementioned gazette describes that partial separation on the interface between the oxide superconductor and the metal tube caused in sintering can be prevented according to this method by setting the metal tube in the high-pressure state.

More specifically, the metal tube filled with the oxide superconducting powder can be press-fitted to a sintered body by holding the metal tube in a high-pressure state of 500 to 2000 kg/cm$^2$ (about 50 to 200 MPa) at least either in the heat treatment or after the heat treatment. Thus, when the superconductor partially causes quenching, heat resulting from this quenching can be quickly removed. In addition, it is also possible to prevent deterioration of the superconductivity resulting from a separation part forming a stress concentration part causing distortion.

Patent Document 1: Japanese Patent Laying-Open No. 5-101723
Patent Document 2: Japanese Patent No. 2592846 (Japanese Patent Laying-Open No. 1-30114)
Patent Document 3: WO 01/22436
Patent Document 4: US 6069116

Disclosure of the Invention

Problems to be Solved by the Invention

In Japanese Patent Laying-Open No. 5-101723, however, the internal pressure obtained following heat-up in the closed vessel is about 4 atm (0.4 MPa). Thus, voids are formed between oxide superconducting crystals in sintering, to disadvantageously reduce the critical current density.

Further, the oxide superconducting wire cannot be sufficiently inhibited from blistering caused in sintering due to the internal pressure of about 4 atm (0.4 MPa), and hence the critical current density is also disadvantageously reduced.

In the method according to Japanese Patent No. 2592846, it is difficult to control the partial oxygen pressure in the heat treatment due to application of the excessively high pressure of 500 to 2000 kg/cm$^2$ (about 50 MPa to 200 MPa), to reduce the critical current density.

Accordingly, an object of the present invention is to provide a method of manufacturing an oxide superconducting wire capable of improving the critical current density by suppressing formation of voids between oxide superconducting crystals and blisters of the oxide superconducting wire while simplifying partial oxygen pressure control in a heat treatment.

Means for Solving the Problems

The invention is defined in the claims.

The method of manufacturing an oxide superconducting wire according to the present invention comprises a step of preparing a wire formed by covering raw material powder of an oxide superconductor with a metal and a heat treatment step of heat-treating the wire in a pressurized atmosphere having a total pressure of at least 1 MPa and less than 50 MPa in the heat treatment. At a heat-up time before the heat treatment in the heat treatment step, pressurization is started from a temperature reducing the 0.2 % yield strength of the metal below the total pressure in the heat treatment.

According to the method of manufacturing an oxide superconducting wire, a pressure is applied to the wire in a state where the 0.2 % yield strength of the metal is smaller than the total pressure of the pressurized atmosphere in the heat treatment. Thus, the portion of the metal is readily compressed through compressive force resulting from pressurization due to an effect similar to that of hot working. Therefore, the wire is compressed before pressurizing gas penetrates into the wire through pinholes, whereby formation of voids and blisters can be sufficiently suppressed by the pressurization. Consequently, the sintering density of the oxide superconductor can be improved, and the critical current density of the oxide superconducting wire can be improved.

The method of manufacturing an oxide superconducting wire according to the present invention comprises a step of preparing a wire formed by covering raw material powder of an oxide superconductor with a metal including silver and a heat treatment step of heat-treating the wire in a pressurized atmosphere having a total pressure of at least 1 MPa and less than 50 MPa in the heat treatment. At a heat-up time before the heat treatment in the heat treatment step, pressurization is started after the temperature of the atmosphere exceeds 400°C.

According to this method of manufacturing an oxide superconducting wire, a pressure is applied to the wire in a state where 0.2 % yield strength of the metal including silver is reduced to a level substantially identical to the total pressure of the pressurized atmosphere in the heat treatment. Thus, the portion of the metal is readily compressed through compressive force resulting from pressurization due to an effect similar to that of hot working. Therefore, the wire is compressed before pressurizing gas penetrates into the wire through pinholes, whereby formation of voids and blisters can be sufficiently suppressed by the pressurization. Consequently, the sintering density of the oxide superconductor can be improved, and the critical current density of the oxide superconducting wire can be improved.

Preferably in the aforementioned manufacturing method, the pressurization is started after the temperature of the atmosphere exceeds 600°C at the heat-up time before the heat treatment in the heat treatment step.

Thus, the pressure is applied to the wire in a state where the 0.2 % yield strength of the metal including silver is reduced to about half the total pressure of the pressurized atmosphere in the heat treatment. Therefore, the portion of the metal is further readily compressed through the compressive force resulting from the pressurization. Consequently, the sintering density of the oxide superconductor can be further improved, and the critical current density of the oxide superconducting wire can be further improved.

Preferably in the aforementioned manufacturing method, the speed of pressurization is at least 0.05 MPa/min.

The speed of the pressurizing gas penetrating into the wire through pinholes is less than about 0.05 MPa/min. in the heat treatment step. When the total pressure of the atmosphere is controlled to continuously increase at a speed of at least 0.05 MPalmin. at the heat-up time before the heat treatment, therefore, the pressure in the atmosphere can be regularly kept higher than the pressure in the wire. Thus, compressive force can be applied to the wire at the heat-up time before the heat treatment whether or not the wire has pinholes before the heat treatment step, whereby formation of voids and blisters is suppressed. Consequently, the sintering density of the oxide superconductor can be effectively improved due to the heat treatment in the pressurized atmosphere of at least 1 MPa and less than 50 MPa, and the critical current density of the oxide superconducting wire can be effectively improved.

Preferably in the aforementioned manufacturing method, the speed of pressurization is at least 0.1 MPa/min.

Thus, the pressure in the atmosphere can be kept further higher than the pressure in the wire. Therefore, the compressive force can be further largely applied to the wire at the heat-up time before the heat treatment whether or not the wire has pinholes before the heat treatment step, whereby formation of voids and blisters is suppressed. Consequently, the sintering density of the oxide superconductor can be further effectively improved due to the heat treatment in the pressurized atmosphere of at least 1 MPa and less than 50 MPa, and the critical current density of the oxide superconducting wire can be further effectively improved.

Preferably in the aforementioned manufacturing method, the heat treatment step is carried out in an oxygen atmosphere, and the partial oxygen pressure is at least 0.003 MPa and not more than 0.02 MPa.

When the partial oxygen pressure is kept in the range of at least 0.003 MPa and not more than 0.02 MPa in the heat treatment, a stable oxide superconducting phase is formed and the critical current density can be improved. A non-superconducting phase is formed if the partial oxygen pressure exceeds 0.02 MPa, while the oxide superconducting phase is hardly formed and the critical current density is reduced if the partial oxygen pressure is less than 0.003 MPa.

Preferably in the aforementioned manufacturing method, the raw material powder of the oxide superconductor includes a Bi2223 phase, and the oxide superconducting wire is annealed in an oxygen-containing atmosphere of a temperature of at least 300°C and not more than 600°C in the heat treatment step.

The Bi2212 phase is included in an oxide superconductor mainly composed of a Bi2223 phase and have made deep studies to find that the oxygen content of the Bi2212 phase changes when the oxide superconductor is annealed in an oxygen atmosphere to improve the critical current density at a low temperature of about 20 K. The principle of the improvement of the critical current density at the low temperature of about 20 K is now described.

An oxide superconductor (oxide superconductor filaments) of an oxide superconducting wire includes a Bi2212 phase in addition to a main phase of a Bi2223 phase (no wire of an oxide superconductor consisting of a 2223 phase by 100 % is implemented at present). When this wire is annealed in an oxygen atmosphere so that the Bi2212 phase absorbs oxygen, low-temperature characteristics of the wire are improved due to the following properties:

(1) As to Bi2212 Phase

In the Bi2212 phase, the oxygen content remarkably changes when the wire is annealed in an oxygen atmosphere. In other words, a value $\underline{z}$ in $(BiPb)_2Sr_2Ca_1Cu_2O_{8+z}$ changes due to the annealing in the oxygen atmosphere, to change the critical temperature ($T_c$) and the critical current density ($J_c$) of the Bi2212 phase. More specifically, the critical temperature $T_c$ is reduced (changes in the range of 70 K to 90 K) when the value $\underline{z}$ is increased. Further, the critical current density $J_c$ is increased at a low temperature of about 20 K, while the critical current density $J_c$ is reduced at a high temperature of about 77 K.

This change is caused since the concentration of carriers (holes) bearing conduction is increased when the oxygen content in the Bi2212 phase is increased. In other words, the critical temperature $T_c$ is reduced if oxygen is excessively introduced since there is an optimum hole concentration increasing $T_c$ in relation to the critical temperature $T_c$, while the critical current density $J_c$ is improved since electrical conduction is improved as the carrier concentration is increased in relation to the critical current density $J_c$ at a temperature sufficiently lower than the critical temperature $T_c$. In relation to the critical current density $J_c$ at a high temperature, the critical temperature $T_c$ (77 K, for example: since the critical temperature $T_c$ of the Bi2212 phase is close to or not more than the same) is reduced and hence the critical current density $J_c$ is also reduced.

(2) As to Bi2223 Phase

The Bi2223 phase extremely hardly absorbs or discharges oxygen, and the oxygen content thereof hardly changes when the wire is annealed in the oxygen atmosphere. In other words, the value $\underline{z}$ in $(BiPb)_2Sr_2Ca_2Cu_3O_{10+z}$ substantially remains at zero. Therefore, the critical temperature $T_c$ and the critical current density $J_c$ of the Bi2223 phase remain unchanged when the wire is annealed in the oxygen atmosphere.

As understood from Table 1 showing the aforementioned results, the properties of the Bi2223 phase are not changed by the annealing in the oxygen atmosphere, while the Bi2212 phase contains oxygen to change the properties thereof and hence the critical current density $J_c$ is improved at the low temperature of about 20 K in the overall wire.

[Table 1]

| | | | Before Annealing | After Annealing |
|---|---|---|---|---|
| | (1) | Performance of Bi2223 Phase (Tc and Jc under high and low temperatures) | → | unchanged |
| | (2) | Tc of Bi2212 Phase | high | low |
| | (3) | Jc of Bi2212 Phase under High Temperature (about 77 K) | high | low (for the above reason (2)) |
| | (4) | Jc of Bi 2212 Phase under Low Temperature (not more than 20 K) | low | high |
| | (5) | Jc of Overall Wire under High Temperature (about 77 K) | high | low (for the above reasons (1) + (3)) |
| | (6) | Jc of Overall Wire under Low Temperature (not more than 20 K) | low | high (for the above reasons (1) + (4)) |

The annealing temperature is so set to at least 300°C and not more than 600°C that the Bi2212 phase can effectively contain oxygen and decomposition of the Bi2223 phase can be prevented. In other words, no oxygen is introduced into/discharged from the Bi2212 phase if the annealing temperature is less than 300°C, while the main Bi2223 phase is decomposed if the annealing temperature exceeds 700°C.

Preferably, the aforementioned manufacturing method further comprises a step of twisting the wire in advance of the heat treatment step. Thus, the twisted oxide superconducting wire can be inhibited from formation of blisters, and the critical current density can be improved.

Preferably in the aforementioned manufacturing method, the wire is not rolled. Thus, a round oxide superconducting wire can be inhibited from formation of blisters.

Preferably in the aforementioned manufacturing method, a wire formed by covering a ceramic-covered rod, obtained by covering the raw material powder with ceramic, with the metal is prepared in the step of preparing the wire formed by covering the raw material powder of the oxide superconductor with the metal. Thus, the oxide superconducting wire having a ceramic covering layer can be inhibited from formation of blisters.

Preferably, the aforementioned manufacturing method further comprises a step of molding the wire into a coil in advance of the heat treatment step. Thus, deterioration of the critical current value in the coil of the oxide superconducting wire can be effectively suppressed while inhibiting the wire from blistering.

Preferably in the aforementioned manufacturing method, the wire is held under a decompressed atmosphere before the pressurization in the heat treatment step is started.

Preferably in the aforementioned modifying method, the oxide superconducting wire is held under a decompressed atmosphere before the pressurization in the heat treatment step is started.

Thus, the pressure in the atmosphere does not exceed the pressure in the wire in the state before the pressurization in the heat treatment is started, whereby gas hardly penetrates into the wire, and formation of blisters on the wire can be further suppressed. In the oxide superconducting wire according to the present invention, the sintering density of an oxide superconductor is at least 95 %.

When employing the method of manufacturing an oxide superconducting wire according to the present invention, it is possible to obtain an oxide superconducting wire having an oxide superconductor exhibiting a high sintering density. The critical current density of the oxide superconducting wire can be improved by increasing the sintering density of the oxide superconductor in the oxide superconducting wire.

Throughout the specification, the term "Bi2223 phase" denotes a Bi-Pb-Sr-Ca-Cu-O oxide superconducting phase containing bismuth, lead, strontium, calcium and copper in atomic ratios of (bismuth and lead):strontium:calcium:copper approximately expressed as 2:2:2:3, more specifically a $(BiPb)_2Sr_2Ca_2Cu_3O_{10+z}$ superconducting phase.

Further, the term "Bi2212 phase" denotes a Bi-Pb-Sr-Ca-Cu-O oxide superconducting phase containing bismuth, lead, strontium, calcium and copper in atomic ratios of (bismuth and lead):strontium:calcium:copper approximately expressed as 2:2:1:2, more specifically a $(BiPb)_2Sr_2Ca_1Cu_2O_{8+z}$ superconducting phase.

Effects of the Invention

According to the inventive method of manufacturing an oxide superconducting wire, the pressure is applied to the wire while the 0.2 % yield strength of the metal is smaller than the total pressure of the pressurized atmosphere in the heat treatment. Thus, the portion of the metal is readily compressed through the compressive force resulting from the pressurization due to an effect similar to that of hot working. Therefore, the wire is compressed before the pressurizing gas penetrates into the wire through pinholes, whereby formation of voids and blisters can be sufficiently suppressed by the pressurization. Consequently, the sintering density of the oxide superconductor can be improved, and the critical current density of the oxide superconducting wire can be improved.

Brief Description of the Drawings

[Fig. 1] A diagram showing a partially fragmented perspective view conceptually illustrating the structure of an oxide superconducting wire.

[Fig. 2] A diagram showing manufacturing steps for an oxide superconducting wire according to a first example of the present invention.

[Fig. 3] A schematic sectional view of a hot isostatic pressing (HIP) apparatus.

[Fig. 4] (a) to (d) are conceptual diagrams showing behavior of voids between oxide superconducting crystals stepwise.

[Fig. 5] A diagram showing the relation between total pressures P (MPa) of a pressurized atmosphere and numbers (/10 m) of blisters on a wire.

[Fig. 6] A diagram showing total pressures and partial oxygen pressures as to a gas mixture containing about 80 % of nitrogen and about 20 % of oxygen.

[Fig. 7] A diagram showing the relation between total pressures and oxygen concentration values in a case of setting the partial oxygen pressure constant.

[Fig. 8] A partially fragmented perspective view conceptually showing the structure of an oxide superconducting wire having pinholes.

[Fig. 9A] A graph showing thicknesses of an oxide superconducting wire having no pinholes before and after a heat treatment in a pressurized atmosphere.

[Fig. 9B] A graph showing thicknesses of an oxide superconducting wire having pinholes before and after a heat treatment in a pressurized atmosphere.

[Fig. 10] A diagram showing the relation between temperatures and pressures in a heat treatment step and time in a second example of the present invention.

[Fig. 11] A diagram showing exemplary relation between temperatures, total pressures and partial oxygen pressures at a heat-up time before a heat treatment and in the heat treatment and time in a third embodiment of the present invention.

[Fig. 12] A diagram showing the relation between pressing speeds and sintering densities under various temperatures for starting pressurization.

[Fig. 13] A diagram showing temperature dependency of 0.2 % yield strength of silver.

[Fig. 14] A diagram showing the relation between sintering densities of oxide superconductors and critical current values of oxide superconducting wires.

[Fig. 15] A diagram showing exemplary relation between temperatures, total pressures and partial oxygen pressures in a case of performing annealing after a heat treatment in a fourth embodiment of the present invention and time.

[Fig. 16] A diagram showing critical current values of oxide superconducting wires before annealing and after annealing at a temperature of 500°C under respective temperatures.

[Fig. 17] A partially fragmented perspective view conceptually showing the structure of a twisted oxide superconducting wire.

[Fig. 18] A diagram showing manufacturing steps for the twisted oxide superconducting wire.

[Fig. 19] A partially fragmented perspective view schematically showing a state of twisting a multifilamentary wire.

[Fig. 20] A partially fragmented perspective view conceptually showing the structure of a round oxide superconducting wire.

[Fig. 21] A sectional view conceptually showing the structure of an oxide superconducting wire having a ceramic covering layer.

[Fig. 22] A diagram schematically showing a first step of a method of manufacturing an oxide superconducting wire according to a sixth embodiment of the present invention.

[Fig. 23] A diagram schematically showing a second step of the method of manufacturing an oxide superconducting wire according to the sixth embodiment of the present invention.

[Fig. 24] A diagram schematically showing a third step of the method of manufacturing an oxide superconducting wire according to the sixth embodiment of the present invention.

[Fig. 25] A perspective view showing the structure of a coiled oxide superconducting wire.

[Fig. 26] A diagram showing manufacturing steps for an oxide superconducting wire according to a seventh example of the present invention.

Description of the Reference Signs

1, 1a, 1b oxide superconducting wire, 2, 2a to 2c oxide superconductor filament, 3, 3 a to 3c sheath part, 4 gas inlet, 5 top cover, 6 pressure vessel cylinder, 7 thermal barrier, 8 treated object, 9 heater, 10 bearer, 11 bottom cover, 12 superconducting crystal, 13 apparatus, 14 pinhole, 21 ceramic covering layer, 22 ceramic-covered rod, 25 rod.

Best Modes for Carrying Out the Invention

Examples and embodiments of the present invention are now described with reference to the drawings.

(First Example)

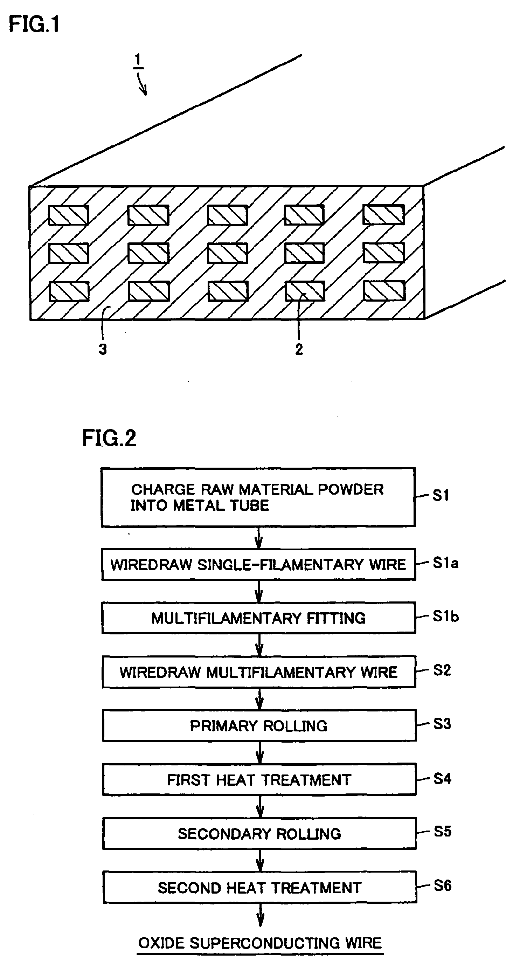

Fig. 1 is a partially fragmented perspective view conceptually showing the structure of an oxide superconducting wire.

A multifilamentary oxide superconducting wire, for example, is described with reference to Fig. 1. An oxide superconducting wire 1 has a plurality of oxide superconductor filaments 2 extending in the longitudinal direction and a sheath part 3 covering the same. The material for each of the plurality of oxide superconductor filaments 2 preferably has a Bi-Pb-Sr-Ca-Cu-O composition, for example, and a material including a Bi2223 phase having atomic ratios of (bismuth and lead):strontium:calcium:copper approximately expressed as 2:2:2:3 is optimum in particular. The material for the sheath part 3 consists of silver, for example.

While a multifilamentary wire has been described in the above, an oxide superconducting wire having a single-filamentary wire structure comprising a single oxide superconductor filament 2 covered with a sheath part 3 may alternatively be employed.

A method of manufacturing the aforementioned oxide superconducting wire is now described.

Fig. 2 is a diagram showing manufacturing steps for the oxide superconducting wire according to the first example of the present invention.

Referring to Fig. 2, raw material powder of an oxide superconductor is first filled into a metal tube (step S1). The raw material powder of the oxide superconductor consists of a material including a Bi2223 phase, for example.

Silver or a silver alloy having high heat conductivity is preferably employed for the metal tube. Thus, heat generated when the superconductor partially causes quenching can be quickly removed from the metal tube.

Then, the aforementioned wire is wiredrawn thereby forming a single-filamentary wire having a core material of a precursor covered with a metal such as silver (step S 1 a). Then, a large number of such single-filamentary wires are bundled and fitted into a metal tube of a metal such as silver, for example (multifilamentary fitting: step S1b). Thus, a wire of a multifilamentary structure having a large number of core materials of the raw material powder is obtained. Then, the wire of the multifilamentary structure is wiredrawn thereby forming a multifilamentary wire of the raw material powder embedded in a sheath part of silver or the like, for example (step S2). Thus, a multifilamentary wire formed by covering the raw material powder of the oxide superconductor with the metal is obtained.

Primary rolling is performed on this wire (step S3), followed by a first heat treatment (step S4). An oxide superconducting phase is generated from the raw material powder due to these operations. Secondary rolling is performed on this heat-treated wire (step S5). Thus, voids resulting from the first heat treatment are removed. A second heat treatment is performed on the secondarily rolled wire (step S6). Sintering of the oxide superconducting phase progresses while the oxide superconducting phase is simultaneously converted to a single phase through the second heat treatment.

The oxide superconducting wire shown in Fig. 1, for example, can be manufactured according to the aforementioned manufacturing method.

In this example, at least either the first heat treatment (step S4) or the second heat treatment (step S6) is performed in a pressurized atmosphere to which a pressure of at least 1 MPa and less than 50 MPa is applied as the total pressure.

The heat treatment in this pressurized atmosphere is performed by hot isostatic pressing (HIP), for example. This hot isostatic pressing is now described.

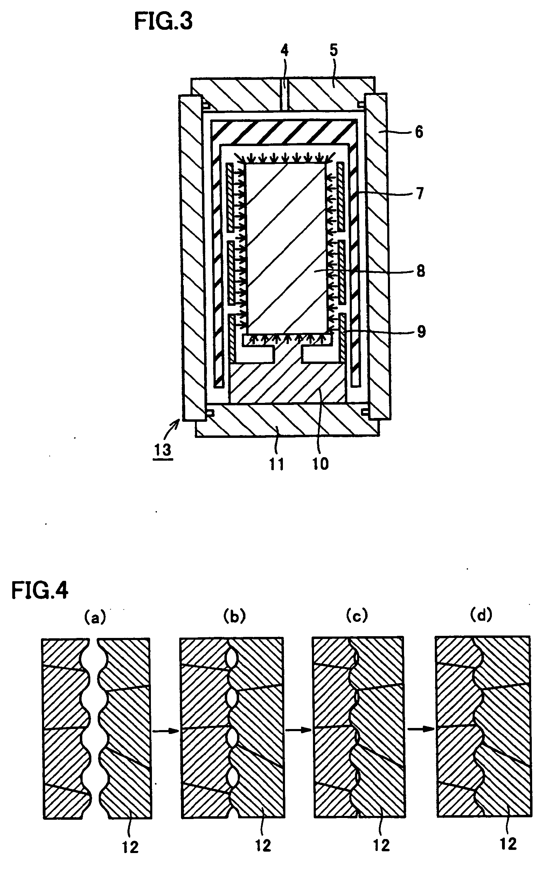

Fig. 3 is a schematic sectional view of an apparatus for performing hot isostatic pressing (HIP).

Referring to Fig. 3, an apparatus 13 for performing hot isostatic pressing is constituted of a pressure vessel cylinder 6, a top cover 5 and a bottom cover 11 closing both ends of the pressure vessel cylinder 6, a gas inlet 4 provided on the top cover 5 for introducing gas into the pressure vessel cylinder 6, a heater 9 heating a treated object 8, a thermal barrier 7 and a bearer 10 supporting the treated object 8.

According to this example, the bearer 10 supports the wire obtained by filling the raw material powder into the metal tube and thereafter wiredrawing/rolling the same as the treated object 8 in the pressure vessel cylinder 6. In this state, prescribed gas is introduced into the pressure vessel cylinder 6 through the gas inlet 4 thereby forming a pressurized atmosphere of at least 1 MPa and less than 50 MPa in the pressure vessel cylinder 6 and heating the wire 8 with the heater 9 to a prescribed temperature under this pressurized atmosphere. This heat treatment is preferably performed in an oxygen atmosphere, and the partial oxygen pressure is preferably at least 0.003 MPa and not more than 0.02 MPa. Thus, the wire 8 is subjected to the heat treatment by hot isostatic pressing.

According to this example, the heat treatment is performed in the pressurized atmosphere of at least 1 MPa and less than 50 MPa as hereinabove described, to mainly attain the following three effects:

First, the number of voids formed between oxide superconducting crystals in the heat treatment can be reduced.

The inventors have found that the number of voids formed between oxide superconducting crystals mainly in a heat treatment can be remarkably reduced by performing the heat treatment in a pressurized atmosphere of at least 1 MPa as compared with a case of less than 1 MPa.

Figs. 4(a) to (d) are conceptual diagrams showing behavior of voids between oxide superconducting crystals stepwise.

Referring to Figs. 4(a) to (d), the contact area between oxide superconducting crystals 12 formed in a heat treatment increases due to plastic flow when the heat treatment is performed in a pressurized atmosphere, to reduce the number of voids of several $\mu$m to several 10 $\mu$m present between the superconducting crystals 12 (Fig. 4(a) → Fig. 4(b)). When held in this state, creep deformation is caused as shown in Fig. 4(c) so that voids present on the junction interface shrink while a contaminative portion such as an oxide film is partially broken/decomposed to cause diffusion of atoms and progress sintering. The voids between the superconducting crystals 12 finally substantially disappear as shown in Fig. 4(d), and a stable junction interface is formed.

To pass a current through a superconducting wire is to pass a current between superconducting crystals constituting the superconducting wire. What limits the quantity of a current passable while keeping a superconducting state (causing no electric resistance) in a refrigerant (e.g., liquid nitrogen or helium, or a refrigerator) for employing a superconducting wire is generally the junction between superconducting crystals having a weak superconducting state (the superconducting crystals have stronger superconductivity than the junction between the crystals). Voids inevitably remain in the junction between the superconducting crystals in normal atmospheric sintering. When the number of voids between the superconducting crystals is reduced, therefore, the performance of the superconducting wire is so improved that reduction of the critical current density can be prevented.

More specifically, the sintering density of an oxide superconductor heat-treated in the atmospheric pressure was 80 to 90% as to an oxide superconducting wire containing a Bi2223 phase, while the sintering density of an oxide superconductor prepared by setting the total pressure of a pressurized atmosphere to 10 MPa was 93 to 96 %, and reduction of the number of voids formed between oxide superconducting crystals was observed.

Second, the oxide superconducting wire can be prevented from blisters formed in the heat treatment.

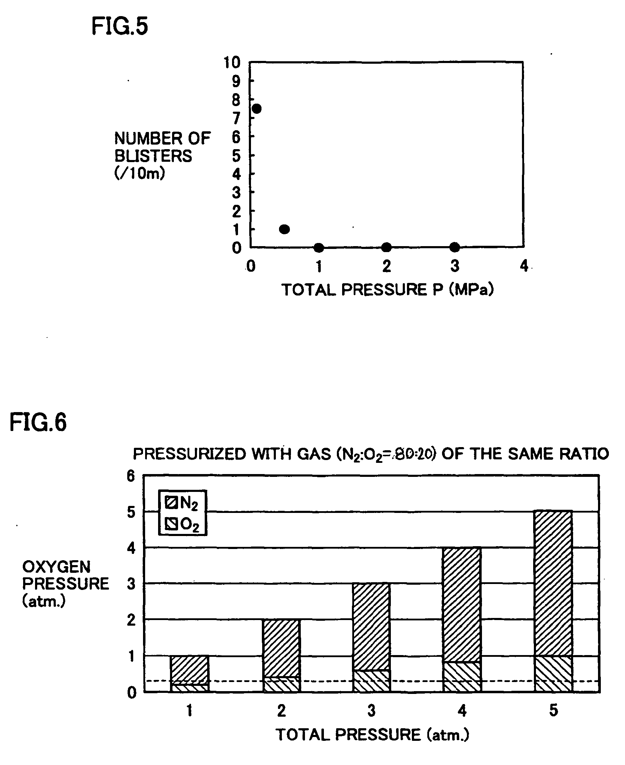

The inventors have investigated the number of blisters formed in a heat-treated wire when varying the total pressure for heat-treating an oxide superconducting wire in a pressurized atmosphere. Fig. 5 is a diagram showing the relation between total pressures P (MPa) of a pressurized atmosphere and numbers (/10 m) of blisters of a wire. Referring to Fig. 5, it is understood that the number of blisters in the oxide superconducting wire is remarkably reduced when the total pressure of the pressurized atmosphere exceeds 0.5 MPa and the blisters in the oxide superconducting wire substantially disappear when the total pressure is in excess of 1 MPa. Such results have been obtained conceivably for the following reason:

Powder of an oxide superconductor is generally filled into a metal tube at a filling factor of about 80 % of the theoretical density before sintering, and hence gas is present in voids of the powder. The gas in the voids of the powder causes cubic expansion when reaching a high temperature in a heat treatment, to blister the wire. According to this example, however, the heat treatment is performed in the pressurized atmosphere of at least 1 MPa, and hence the pressure outside the metal tube can increase beyond that in the metal tube. Thus, the wire is conceivably prevented from blisters caused by the gas in the voids of the powder.

The inventors have further studied the cause for blisters of the wire, to also recognize that adsorbates such as carbon (C), water ($H_2O$) and oxygen ($O_2$) adhering to the raw material powder of the oxide superconductor are vaporized during sintering and the volume in the metal tube expands due to this gas to blister the wire. However, such blisters of the wire resulting from vaporization of the adsorbates to the powder can also conceivably be prevented since the external pressure can increase beyond the intermetallic internal pressure by performing the heat treatment in the pressurized atmosphere of at least 1 MPa.

Thus, it is conceivably possible to substantially remove not only blisters resulting from the gas present in the voids of the raw material powder of the oxide superconductor but also blisters resulting from vaporization of the adsorbates adhering to the surfaces of particles thereof. The blisters of the oxide superconducting wire cause reduction of the critical current density, and hence reduction of the critical current density can be prevented by preventing the wire from blisters.

Third, the partial oxygen pressure can be readily controlled in the heat treatment.

The inventors have found that a 2223 phase of a Bi-based oxide superconductor is stably formed when the partial oxygen pressure is controlled to at least 0.003 MPa and not more than 0.02 MPa regardless of the total pressure. A non-superconducting phase such as $Ca_2PbO_4$ is formed if the partial oxygen pressure exceeds 0.02 MPa, while the Bi2223 phase is hardly formed and the critical current density is reduced if the partial oxygen pressure is less than 0.003 MPa.

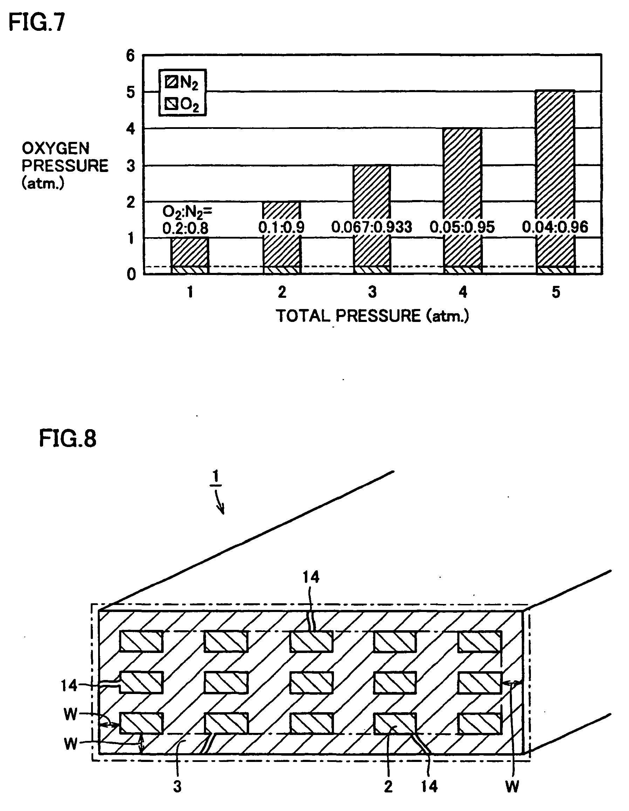

Fig. 6 is a diagram showing total pressures and partial oxygen pressures as to a gas mixture containing about 80 % of nitrogen and about 20 % of oxygen. Fig. 7 is a diagram showing the relation between total pressures and oxygen concentration values in a case of setting the partial oxygen pressure constant.

Referring to Fig. 6, a Bi2223 phase is stably formed without controlling the partial oxygen pressure when the total pressure of the pressurized atmosphere is the atmospheric pressure of 1 atm (0.1 MPa), for example, since the partial oxygen pressure is equivalent to the level of 0.2 atm (0.02 MPa) shown by a dotted line. As the total pressure of the pressurized atmosphere increases to 2 atm, 3 atm ⋯ (0.2 MPa, 0.3 MPa, ...), however, the partial oxygen pressure also increases to exceed the level of 0.2 atm shown by the dotted line. Consequently, the Bi2223 phase is not stably formed. Therefore, the partial oxygen pressure must be controlled to at least 0.003 MPa and not more than 0.02 MPa by varying the mixing ratio of oxygen gas in a gas mixture, as shown in Fig. 7. A dotted line in Fig. 7 shows the level of 0.2 atm (0.02 MPa) similarly to the dotted line in Fig. 6.

In practice, the partial oxygen pressure is controlled by monitoring the total pressure and the oxygen concentration. In other words, the partial oxygen pressure is calculated by multiplying the value of the total pressure by the oxygen concentration. Therefore, if the total pressure is 50 MPa, for example, the oxygen concentration is 0.01 % when the heat treatment is performed with a partial oxygen pressure of 0.005 MPa. Therefore, the injected gas mixture must be controlled by measuring the oxygen concentration of 0.01 %. However, the oxygen concentration of 0.01 % is substantially identical to a measurement error, and hence it is difficult to control the oxygen gas in the injected gas mixture by correctly measuring this oxygen concentration. According to this example, the total pressure in the pressurized atmosphere is set to less than 50 MPa so that the concentration of the oxygen gas in the injected gas mixture can be kept high to some extent by reducing influence by a measurement error of the oxygen concentration, whereby the partial oxygen pressure can be readily controlled.

While this example has been described with reference to the case of constituting the pressurized atmosphere of nitrogen and oxygen, the pressurized atmosphere may be constituted of rare gas and oxygen. Therefore, the pressurized atmosphere may be constituted of argon and oxygen, for example.

(Second Example)

It has been recognized that formation of voids and blisters can be effectively suppressed by performing a heat treatment in the aforementioned pressure range (at least 1 MPa and less than 50 MPa) when a wire formed by covering raw material powder of an oxide superconducting wire with a metal has no pinholes while formation of voids and blisters cannot be sufficiently suppressed by merely performing a heat treatment in the aforementioned pressure range when the wire has pinholes.

Fig. 8 is a partially fragmented perspective view conceptually showing the structure of an oxide superconducting wire having pinholes. Referring to Fig. 8, pinholes 14 are formed to pass from outside up to oxide superconductor filaments 2. The remaining structure shown in Fig. 8 is substantially identical to the structure shown in Fig. 1, and hence identical members are denoted by identical reference numerals and redundant description is not repeated.

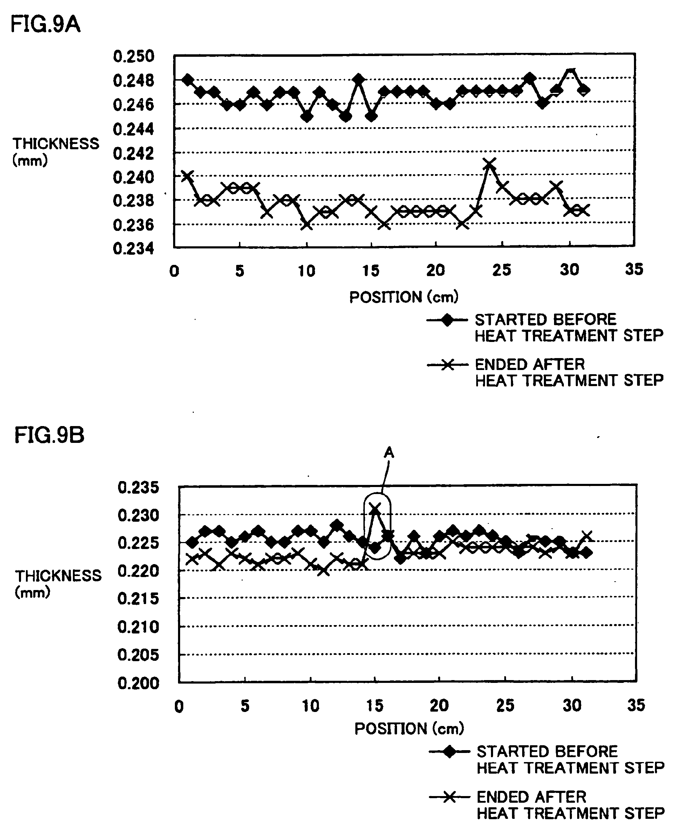

Fig. 9A is a graph showing thicknesses of an oxide superconducting wire having no pinholes before and after a heat treatment step in a pressurized atmosphere, and Fig. 9B is a graph showing thicknesses of an oxide superconducting wire having pinholes before and after a heat treatment step. Heat treatment conditions in Figs. 9A and 9B are a total pressure of 20 MPa, a partial oxygen pressure of 0.008 MPa, a temperature of 825°C in an atmosphere, and a heat treatment time of 50 hours.

Referring to Fig. 9A, the thickness of the oxide superconducting wire having no pinholes is reduced by about 0.006 mm to 0.01 mm after the heat treatment. This is because formation of voids between oxide superconducting crystals and blisters of the oxide superconducting wire is suppressed due to the heat treatment in a pressurized atmosphere having the total pressure of 20 MPa.

Referring to Fig. 9B, on the other hand, the thickness of the oxide superconducting wire having pinholes is reduced only by about 0.002 mm to 0.005 mm after the heat treatment, and formation of voids between oxide superconducting crystals and blisters of the oxide superconducting wire is not sufficiently suppressed. The thickness of a portion (portion A) having pinholes in the wire increases after the heat treatment as compared with that before the heat treatment.

Thus, it has been recognized that formation of voids and blisters can be effectively suppressed by performing the heat treatment in the aforementioned pressure range (at least 1 MPa and less than 50 MPa) when there are no pinholes while formation of voids and blisters cannot be sufficiently suppressed by merely performing the heat treatment in the aforementioned pressure range when there are pinholes.

In the heat treatment in the pressurized atmosphere according to the present invention, plastic flow and creep deformation take place in the superconducting crystals formed in the heat treatment due to the high pressure of at least 1 MPa outside the wire, whereby voids between the oxide superconducting crystals formed in the heat treatment are suppressed. Further, the gas in the voids of the oxide superconducting crystal powder formed in the heat treatment or the gas adhering to the oxide superconducting crystal powder formed in the heat treatment can be inhibited from expansion in the heat treatment due to the pressure from outside the metal tube, whereby the oxide superconducting wire is inhibited from formation of blisters. Consequently, reduction of the critical current density resulting from voids and blisters is prevented.

In a wire having pinholes, however, pressurizing gas penetrates into the wire through the pinholes also when the aforementioned heat treatment in the pressurized atmosphere is performed. Therefore, no difference is caused between the internal and external pressures of the wire and formation of voids and blisters is not sufficiently suppressed by the heat treatment in the pressurized atmosphere. Consequently, the effect of preventing reduction of the critical current density is reduced.

Referring to Fig. 8, the thickness W of a sheath part 3 may be increased, in order not to form the pinholes 14 passing from outside up to oxide superconductor filaments 2. If the thickness W of the sheath part 3 is increased, however, the ratio of the oxide superconductor filaments 2 in an oxide superconducting wire 1 is reduced to reduce the quantity of current passable per unit area. Therefore, the inventors have made deep studies, to find that formation of voids and blisters can be suppressed for improving the critical current density without increasing the thickness W of the sheath part 3 also in a wire having pinholes by employing a technique described below.

According to this technique, pressurization is performed at a speed of at least 0.05 NTa/min. at a heat-up time before a heat treatment in at least either a first heat treatment (step S4) or a second heat treatment (step S6). In the heat treatment, the total pressure in the atmosphere is controlled to continuously increase. In cool-down time immediately after the heat treatment, further, control is made to compensate for reduction of the pressure resulting from temperature reduction (to add a pressure).

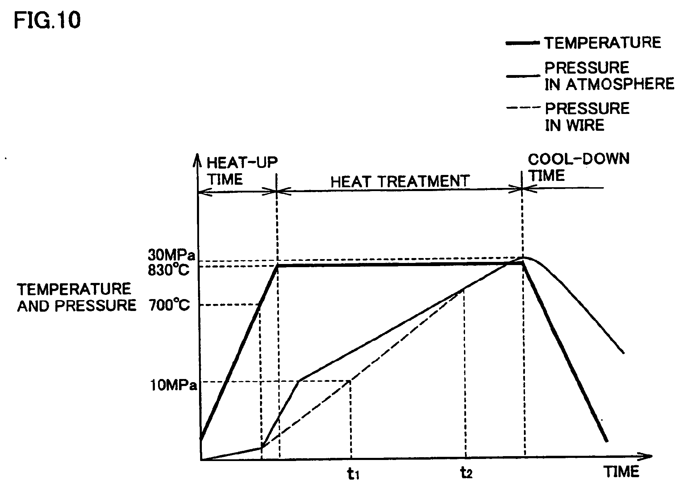

Fig. 10 is a diagram showing the relation between temperatures and pressures in a heat treatment step and time in a second example of the present invention.

Referring to Fig. 10, the pressure is gently increased according to the state equation of gas at a heat-up time before the heat treatment if the temperature of the atmosphere is not more than 700°C, for example. When the temperature of the atmosphere substantially exceeds 700°C, the pressure in the atmosphere is increased to about 10 MPa. At this time, the pressure in the atmosphere is increased at a blast with a pressing speed of at least 0.05 MPa/min.

The inventors have found that the speed of pressurizing gas penetrating into a wire through pinholes is less than about 0.05 NPa/min. when an oxide superconducting wire having the pinholes is heat-treated in a pressurized atmosphere. Therefore, the pressure in the atmosphere can be kept higher than that in the wire at the heat-up time before the heat treatment by controlling the total pressure of the atmosphere to continuously increase at a speed of at least 0.05 MPa/min. at the heat-up time before the heat treatment.

Thereafter the temperature is kept at 830°C, for example, in the heat treatment. On the other hand, the pressure in the atmosphere is continuously increased. While the pressing speed in the heat treatment is preferably as high as possible, the total pressure exceeds 50 MPa if the pressing speed is excessively high and hence the pressure must be continuously increased at such a proper pressing speed that the total pressure in the heat treatment does not exceed 50 MPa. Referring to Fig. 10, the pressure is increased to about 30 MPa. Therefore, the time when the pressure in the wire and that in the atmosphere are equalized with each other can be retarded from a time $t_1$ to a time $t_2$ as compared with a case where the pressure is kept constant in the heat treatment. Thus, the state where the pressure in the atmosphere is higher than that in the wire can be continuously kept longer in the heat treatment.

Thereafter in cool-down time immediately after the heat treatment, the pressure starts to lower according to the state equation of gas following reduction of the temperature in the atmosphere. At this time, the pressure is controlled to compensate for reduction of the pressure resulting from temperature reduction (to add a pressure). In order to form a stable oxide superconducting phase, the partial oxygen pressure is controlled to be regularly in the range of 0.003 to 0.02 MPa.

According to this technique, the pressure in the atmosphere increases beyond that in the wire at the heat-up time before the heat treatment, whereby compressive force can be applied to the wire. Further, the state where the pressure in the atmosphere is higher than that in the wire can be continuously kept longer in the heat treatment. Consequently, formation of voids and blisters is suppressed at the heat-up time before the heat treatment and at the heat-up time, whereby reduction of the critical current density can be effectively suppressed due to the heat treatment in the pressurized atmosphere of at least 1 MPa and less than 50 MPa.

(Third Embodiment)

The inventors have further made deep studies, to find that the critical current density of an oxide superconducting wire can be further improved by employing a technique described below.

According to this technique, pressurization is started when the temperature of the atmosphere exceeds 400°C, preferably 600°C at the heat-up time before the heat treatment in at least either the first heat treatment step (step S4) or the second heat treatment step (step S6) shown in Fig. 2. The pressurization is preferably performed at a pressing speed of at least 0.05 MPa/min. more preferably at least 0.1 MPa/min.

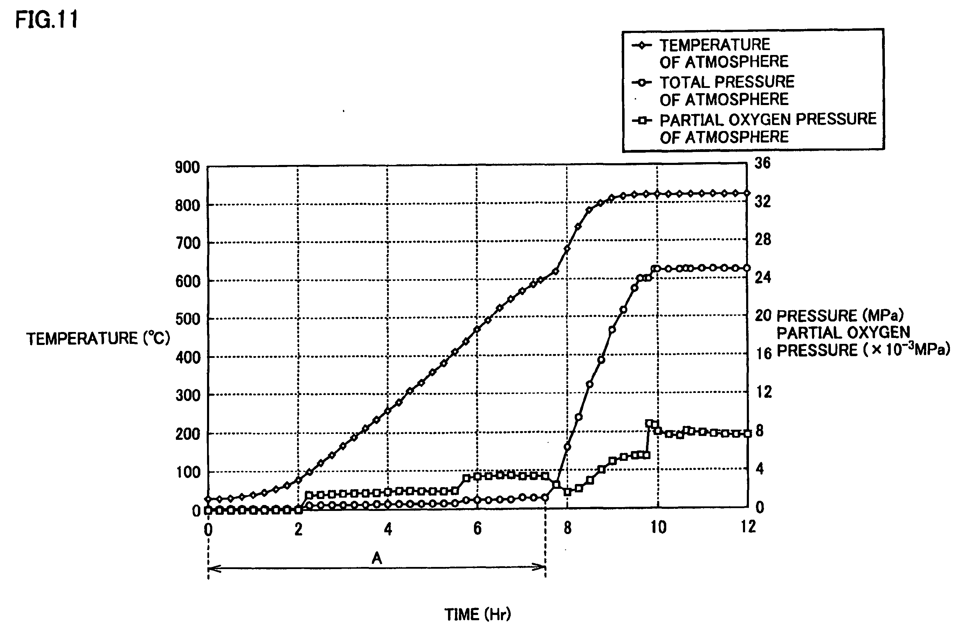

Fig. 11 is a diagram showing exemplary relation between temperatures, total pressures and partial oxygen pressures at a heat-up time before a heat treatment and in the heat treatment and time in a third embodiment of the present invention.

Referring to Fig. 11, the temperature of the atmosphere is gently increased up to 820°C. The pressure of the atmosphere is gently increased according to a state equation of gas when the temperature is less than 600°C. Pressurization is started after the temperature of the atmosphere reaches 600°C, and performed up to about 25 MPa at a pressing speed of about 0.1 MPa/min. The partial oxygen pressure is held in the range of at least 0.003 MPa and less than 0.02 MPa.

The critical current density of an oxide superconducting wire can be further improved by performing a heat treatment under these conditions. In order to confirm the effect of the aforementioned heat treatment method, the inventors have made the following experiment:

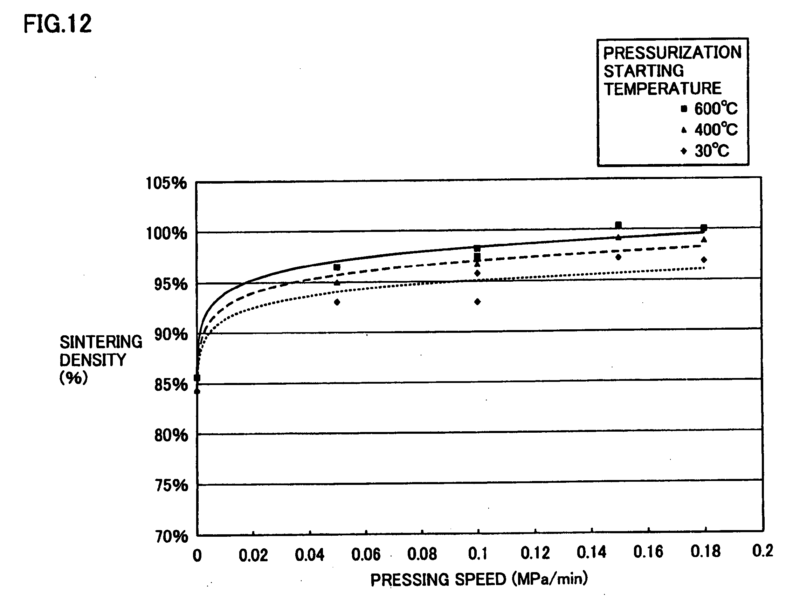

Fig. 12 is a diagram showing the relation between pressing speeds and sintering densities under various temperatures for starting pressurization.

Referring to Fig. 12, the sintering densities of oxide superconductor filaments (oxide superconductors) are about 93 % to 96 % at pressing speeds of at least 0.05 MPa/min. in a case of starting pressurization when the temperature of an atmosphere is 30°C. In a case of starting pressurization after the temperature of the atmosphere reaches 400°C, on the other hand, the sintering densities of the oxide superconductor filaments are at least about 95 % at the pressing speeds of at least 0.05 MPa/min. In a case of starting pressurization after the temperature of the atmosphere reaches 600°C, further, the sintering densities of the oxide superconductor filaments are at least about 97 % at the pressing speeds of at least 0.05 MPa/min., and the sintering densities of the oxide superconductor filaments are at least about 98 % at pressing speeds of at least 0.1 MPa/min. In both cases of starting pressurization after the temperature of the atmosphere reaches 400°C and 600°C respectively, in addition, the sintering densities of the oxide superconductor filaments are at least about 99 % at pressing speeds of at least 0.15 MPa/min. The sintering density is improved at a pressing speed of at least 0.05 MPa/min. conceivably because the speed of pressurizing gas penetrating into the wire through pinholes is less than about 0.05 MPa/min. and the pressure in the atmosphere can be regularly kept higher than that in the wire since the wire is pressurized at a speed faster than this penetration speed. It is understood from the results shown in Fig. 12 that the sintering density of the oxide superconductor filaments is improved when the pressurization is started after the temperature of the atmosphere exceeds 400°C, preferably 600°C. It is also understood that the sintering density of the oxide superconductor filaments is further improved when the speed of pressurization is set to preferably at least 0.05 MPa/min. more preferably at least 0.1 MPa/min. This is conceivably for the following reason:

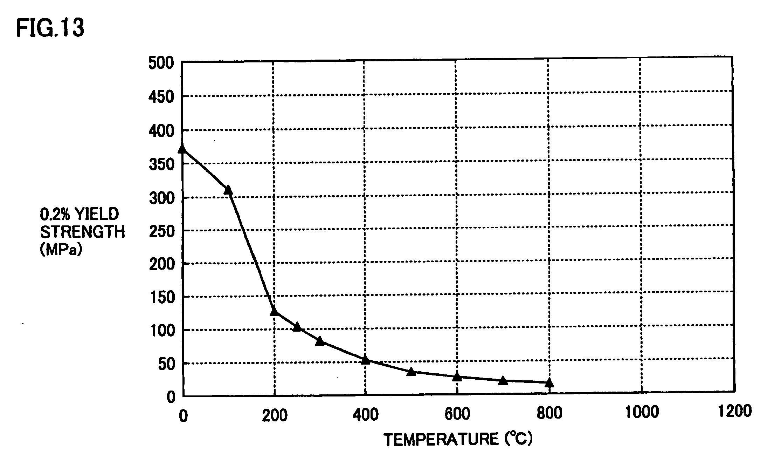

Fig. 13 is a diagram showing temperature dependency of 0.2 % yield strength of silver.

Referring to Fig. 13, the 0.2 % yield strength of silver is about 370 MPa when an atmosphere is at the room temperature, and reduced as the temperature of the atmosphere is increased. In other words, the 0.2 % yield strength is reduced to about 50 MPa when the temperature of the atmosphere reaches 400°C, and the 0.2 % yield strength is reduced to about 25 MPa when the temperature of the atmosphere reaches 600°C. Thus, the 0.2 % yield strength of silver is reduced to a level substantially identical to the total pressure (at least 1 MPa and less than 50 MPa) of the aforementioned pressurized atmosphere when the temperature of the atmosphere is 400°C. Further, the 0.2 % yield strength of silver is reduced to about half the total pressure (at least 1 MPa and less than 50 MPa) of the aforementioned pressurized atmosphere when the temperature of the atmosphere is 600°C. According to the aforementioned technique, it follows that a pressure is applied to the wire when the strength of the sheath part is reduced to a level substantially identical to the total pressure of the pressurized atmosphere. Therefore, the sheath part is readily compressed through compressive force resulting from pressurization due to an effect similar to that of hot working. Consequently, the wire is compressed before the pressurizing gas penetrates into the wire through pinholes, whereby formation of voids and blisters can be sufficiently suppressed by the pressurization, and the sintering density of the oxide superconducting filaments can be improved. The 0.2 % yield strength values shown in Fig. 13 are values obtained by performing a tensile test defined in JIS (Japanese Industrial Standards) on pure silver wires of 1.5 mm in diameter.

The sintering densities of the oxide superconductor filaments shown in Fig. 12 are calculated by the following method: First, each oxide superconducting wire of 5 g (= $M_t$ (g)) is cut out. Then, the cut oxide superconducting wire is dipped in alcohol, for measuring the weight (W (g)) of the wire in alcohol and calculating flotage acting on the oxide superconducting wire. The volume ($V_t$ ($cm^3$)) of the oxide superconducting wire is calculated through the known alcohol density ($\rho = 0.789$ (g/ $cm^3$)). More specifically, the volume $V_t$ is calculated according to the following equations (1) and (2), assuming that $F_t$ represents the flotage:

$$F_t = M_t - W \dots (1)$$

$$V_t = F_t/\rho \dots (2)$$

Then, the oxide superconducting wire is dissolved in nitric acid and silver is determined by performing ICP (inductive coupled plasma) emission spectroscopy on the solution, for calculating the ratio (Y) of silver occupying the weight of the oxide superconducting wire. The weight ($M_f$ (g)) of an oxide superconductor filament part and the weight ($M_s$ (g)) of a sheath part are calculated from the weight of the oxide superconducting wire according to the following equations (3) and (4):

$$M_s = M_t \times Y \ldots (3)$$

$$M_f = M_t - M_s \ldots (4)$$

Then, the volume (($V_s$ (cm$^3$)) of the sheath part is calculated from the known silver gravity (10.5 (g/cm$^3$)), and the volume (($V_f$ (cm$^3$)) of oxide superconductor filaments is calculated from the volume of the sheath part. The density $\rho_f$ of the oxide superconductor filaments is calculated from the volume of the oxide superconductor filaments. More specifically, the density $\rho_f$ is calculated according to the following equations (5) to (7):

$$V_s = M_s/10.5 \ldots (5)$$

$$V_f = V_t - V_s \ldots (6)$$

$$\rho_f = M_f/V_f \ldots (7)$$

On the other hand, a value 6.35 g/cm$^3$ is employed as the theoretical density of the oxide superconductor filaments. This value is calculated by the following method: The atomic ratio of a Bi2223 phase in the oxide superconductor filaments is calculated by ICP emission spectroscopy and EDX (energy dispersive X-ray spectroscopy) analysis. The lattice constant of the Bi2223 phase is obtained by X-ray analysis, for calculating the values of a- and c-axes. The theoretical density is calculated from these values.

The sintering density of the oxide superconductor filaments is calculated from the ratio between the density of the oxide superconductor filaments obtained by the aforementioned method and the theoretical density of the oxide superconductor filaments. More specifically, the sintering density is calculated according to the following equation (8):

$$\text{Sintering Density (\%)} = (\rho_f/6.35) \times 100 \ldots (8)$$

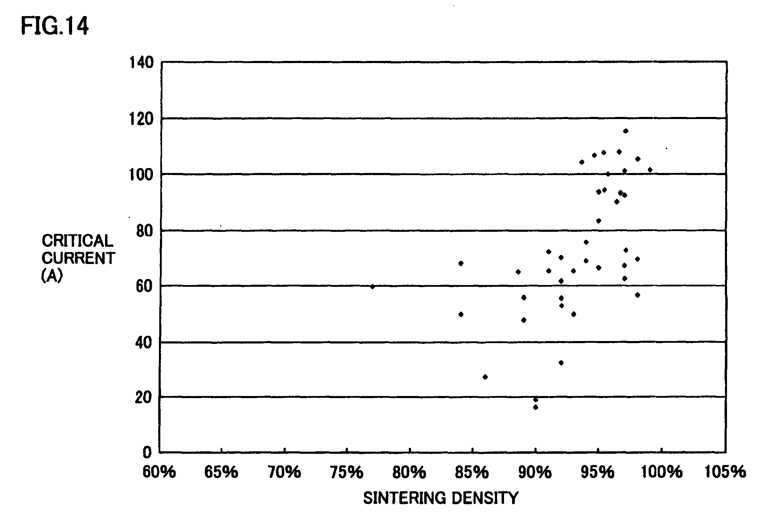

Fig. 14 is a diagram showing the relation between sintering densities of oxide superconductors and critical current values of oxide superconducting wires.

Referring to Fig. 14, the critical current values of oxide superconducting wires having sintering densities of not more than about 95 % are less than 80 A, while the critical current values of oxide superconducting wires having sintering densities of at least about 95 % are mainly in the range exceeding 80 A. The critical current value is obtained by multiplying the critical current density by the sectional area of oxide superconductor filaments, and hence the critical current density is proportionate to the critical current value. Therefore, the critical current density is improved in an oxide superconducting wire having a high sintering density. This is conceivably because a large quantity of current flows to superconducting filaments in the oxide superconducting wire having a high sintering density due to a small number of voids between crystals of the superconducting filaments.

It is understood from the aforementioned results shown in Figs. 12 and 14 that the sintering density of the oxide superconductor filaments is improved and the critical current density of the oxide superconducting wire is improved when pressurization is started after the temperature of the atmosphere exceeds 400°C, preferably 600°C, at a speed of preferably at least 0.05 MPa/min., more preferably at least 0.1 MPa/min.

According to the method of manufacturing the oxide superconducting wire of this embodiment, a pressure is applied to the wire when the 0.2 % yield strength of the sheath part is reduced to a level substantially identical to the total pressure of the pressurized atmosphere in the heat treatment. Thus, the sheath part is readily compressed through compressive force resulting from the pressurization due to an effect similar to that of hot working. Therefore, the wire is compressed before the pressurizing gas penetrates into the wire through pinholes, whereby formation of voids and blisters can be sufficiently suppressed due to the pressurization. Consequently, the sintering density of the oxide superconductor filaments can be improved, and the critical current density of the oxide superconducting wire can be improved.

Preferably in the aforementioned manufacturing method, the pressurization is started after the temperature of the atmosphere exceeds 600°C at the heat-up time before the heat treatment in the heat treatment step.

Thus, a pressure is applied to the wire while the 0.2 % yield strength of the sheath part is reduced to about half the total pressure of the pressurized atmosphere in the heat treatment. Therefore, the sheath part is further readily compressed through the compressive force resulting from the pressurization. Consequently, the sintering density of the filaments of the oxide superconducting wire can be further improved, and the critical current density of the oxide superconducting wire can be further improved.

Preferably in the aforementioned manufacturing method, the speed of the pressurization is at least 0.05 MPa/min. more preferably at least 0.1 MPa/min.

Thus, the sintering density of the oxide superconductor filaments can be further improved, and the critical current density of the oxide superconducting wire can be further improved.

Preferably in the aforementioned manufacturing method, the heat treatment step is carried out in an oxygen atmosphere, and the partial oxygen pressure is at least 0.003 MPa and not more than 0.02 MPa.

Thus, a stable oxide superconducting wire is formed, and the critical current density can be improved. A hetero phase is formed if the partial oxygen pressure exceeds 0.02 MPa, while the oxide superconducting phase is hardly formed and the critical current density is reduced if the partial oxygen pressure is less than 0.003 MPa.

Each of the first to third examples and embodiments has been described with reference to the method of improving the critical current density (method of manufacturing an oxide superconducting wire) by performing a prescribed heat treatment method in at least either the first heat treatment step (step S4) or the second heat treatment step (step S6) shown in Fig. 2.

Further, each of the first to third examples and embodiments has been described with reference to the case of heat-treating the oxide superconducting wire having the sheath part of silver in the pressurized atmosphere having the total pressure of at least 1 MPa and less than 50 MPa in the heat treatment and starting pressurization after the temperature of the atmosphere exceeds 400°C at the heat-up time before the heat treatment in the heat treatment step. However, the method is applicable to all oxide superconducting wires formed by covering oxide superconductors with metals. In this case, the heat treatment is performed in a pressurized atmosphere having a total pressure of at least 1 MPa and less than 50 MPa in the heat treatment, and pressurization is started from a temperature reducing at least 0.2 % yield strength of the metal below the total pressure (at least 1 MPa and less than 50 MPa) in the heat treatment at a heat-up time before the heat treatment in the heat treatment step. Thus, a pressure is applied to the wire in a state where the 0.2 % yield strength of the metal is smaller than the total pressure of the pressurized atmosphere in the heat treatment, whereby the portion of the metal is readily compressed through compressive force resulting from the pressurization. Thus, the sintering density of the oxide superconductor can be improved and the critical current density of the oxide superconducting wire can be improved due to reasons similar to those in the aforementioned oxide superconducting wire having the sheath part of silver.

(Fourth Embodiment)

In general, a bismuth (Bi)-based oxide superconducting wire is known as one of oxide superconducting wires. This Bi-based oxide superconducting wire is usable at the liquid nitrogen temperature, and can obtain a relatively high critical current density. Further, this Bi-based oxide superconducting wire, which is relatively easy to elongate, is expected for application to a superconducting cable or magnet. However, a conventional Bi-based oxide superconducting wire has been disadvantageously unsuitable to application requiring high performance under a low temperature, due to a low critical current density ($J_c$) at a low temperature of about 20 K.

In relation to this, the critical current density of a Bi-based oxide superconducting wire under a low temperature of about 20 K can be improved by combining the following technique with the technique according to each of the first to third examples and embodiments. This technique is now described.

According to this technique, the wire is annealed in an atmosphere containing oxygen at a temperature of at least 300°C and not more than 600°C in at least either the first heat treatment step (step S4) or the second heat treatment step (step S6) shown in Fig. 2.

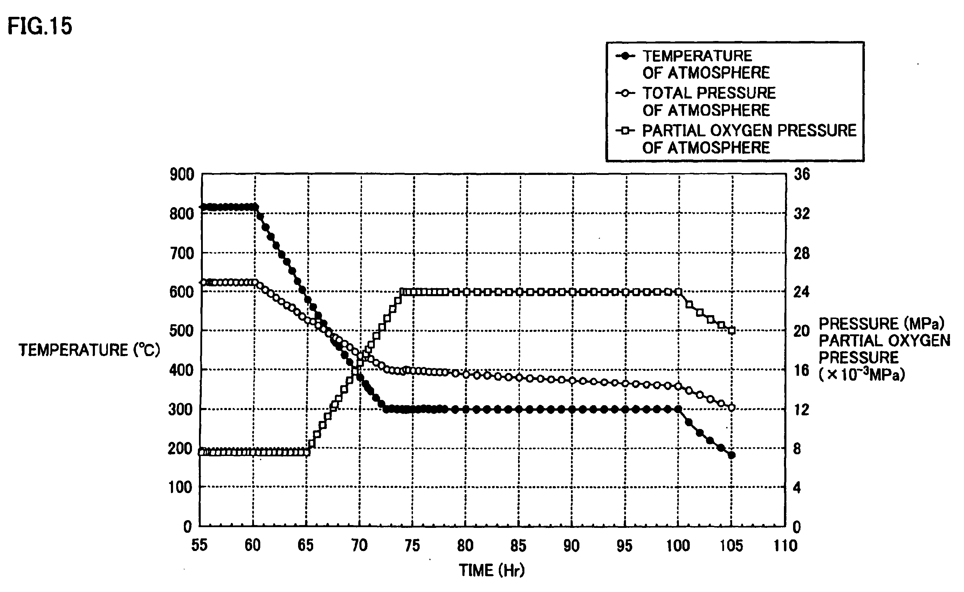

Fig. 15 is a diagram showing exemplary relation between temperatures, total pressures and partial oxygen pressures in a case of performing annealing after a heat treatment in a fourth embodiment of the present invention and time.

Referring to Fig. 15, an oxide superconducting wire is held in an atmosphere having a temperature of 820°C and a total pressure of 25 MPa for a constant time, and thereafter the temperature of the atmosphere is reduced. At this time, the total pressure of the atmosphere is also gently reduced. When the temperature and the pressure of the atmosphere reach about 300°C and about 16 MPa respectively, the oxide superconducting wire is held at a constant temperature and annealed for about 30 hours. While the wire is held at the constant temperature, the total pressure is further continuously gently reduced. The temperature of the atmosphere is reduced again after completion of the annealing. The partial oxygen pressure is about 0.008 MPa during the heat treatment, and increased to about 0.024 MPa during the annealing. The partial oxygen pressure is reduced along with the total pressure after the annealing.

In order to confirm the effect of the aforementioned annealing, the inventors have made the following experiment:

The inventors have investigated the degrees of improvement of critical current values $I_c$ at 20 K as to a case of performing annealing and a case of performing no annealing in heat treatment steps. The annealing was performed for various annealing times under various partial oxygen pressures. Table 2 shows the averages of ratios of increase of critical current values $I_c(22\ K)$ at 22 K to critical current values $I_c(77\ K)$ at 77 K after the heat treatment steps as to respective samples. The critical current values were measured in a magnetic field of 3 T.

[Table 2]

| Sample No. | | Temperature | Time | Partial Oxygen Pressure | Average Value: Ic(20K)/Ic(77K) |
|---|---|---|---|---|---|
| 1 | unannealed | | | | 1.6 |
| 2 | unannealed | | | | 17 |
| 3 | unannealed | | | | 1.5 |
| 4 | annealed | 300°C | 30 h. | 24kPa | 2.1 |
| 5 | annealed | 300°C | 30 h. | 12kPa | 1.9 |
| 6 | annealed | 300°C | 40 h. | 20kPa | 2 |

Referring to Table 2, the averages of the ratios of increase of the critical current values at 22 K in the case of performing no annealing are 1.6, 1.7 and 1.5 respectively. On the other hand, the averages of the ratios of increase of the critical current values at 22 K in the case of performing annealing are 2.1, 1.9 and 2 respectively. Thus, it is understood that the critical current value at 20 K can be improved in the case of performing annealing as compared with the case of performing no annealing.

In order to confirm the effect of annealing the wire in the atmosphere containing oxygen at the temperature of at least 300°C and not more than 600°C, the inventors have made the following experiment:

First, a tape-like Bi-based oxide superconducting wire of a multifilamentary structure having 61 filaments with external sizes of 4.2 mm in width and 0.24 mm in thickness and a silver ratio of 1.5 was prepared. Further, this oxide superconducting wire was heat-treated and annealed in this heat treatment. The annealing was performed in an oxygen jet for an annealing time of 20 hours under various annealing temperatures shown in Table 3. The quantity of a Bi2212 phase in the oxide superconductor was also varied. Table 3 also shows respective critical current values $I_c$ at 77 K and 20 K before the annealing and respective critical current values $I_c$ at 77 K and 20 K after the annealing as to respective samples.

Used wires were selected from the same lot, and it is assumed that the sectional areas of superconducting portions of respective wires are identical to each other. Therefore, the magnitude of the critical current value $I_c$ in the following Table 3 is proportionate to the critical current density $J_c$ ($J_c = I_c$ /sectional area of superconducting portion).

[Table 3]

| Sample No. | Quantity of Bi2212 Phase (%) | Before Annealing 77K Ic(A) | Before Annealing 20K Ic(A)(1) | Annealing Temperature (°C) | After Annealing 77K Ic(A) | After Annealing 20K Ic(A)(2) | (2)/(1) |
|---|---|---|---|---|---|---|---|
| 7 | 9 | 95 | 500 | no | - | - | - |
| 8 | 9 | 95 | 500 | 100 | 95 | 500 | 1.0 |
| 9 | 9 | 95 | 500 | 200 | 95 | 500 | 1.0 |
| 10 | 9 | 95 | 500 | 300 | 94 | 512 | 1.02 |
| 11 | 9 | 95 | 500 | 400 | 92 | 530 | 1.06 |
| 12 | 9 | 95 | 500 | 500 | 90 | 555 | 1.11 |
| 13 | 9 | 95 | 500 | 600 | 89 | 550 | 1.1 |
| 14 | 9 | 95 | 500 | 700 | 70 | 480 | 0.96 |
| 15 | 9 | 95 | 500 | 800 | 60 | 345 | 0.69 |
| 16 | 2 | 100 | 527 | 500 | 99 | 528 | 1.0 |

(continued)

| Sample No. | Quantity of Bi2212 Phase (%) | Before Annealing 77K Ic(A) | Before Annealing 20K Ic(A)(1) | Annealing Temperature (°C) | After Annealing 77K Ic(A) | After Annealing 20K Ic(A)(2) | (2)/(1) |
|---|---|---|---|---|---|---|---|
| 17 | 5 | 97 | 511 | 500 | 96 | 543 | 1.06 |
| 18 | 9 | 95 | 500 | 500 | 90 | 555 | 1.11 |
| 19 | 13 | 92 | 485 | 500 | 88 | 540 | 1.11 |
| 20 | 19 | 90 | 474 | 500 | 82 | 530 | 1.12 |
| 21 | 25 | 83 | 437 | 500 | 75 | 500 | 1.14 |
| 22 | 50 | 60 | 316 | 500 | 50 | 410 | 1.3 |

It is understood from the results shown in Table 3 that the critical current value $I_c$ (critical current density $J_c$) at the low temperature (20 K) is improved as compared with that before the annealing due to the annealing performed in the oxygen atmosphere at the temperature of at least 300°C and not more than 600°C. It is also understood that the critical current value $I_c$ after the annealing exceeds 530 A and the absolute value of the critical current value $I_c$ (critical current density $J_c$) is increased due to the quantity of the Bi2212 phase in the oxide superconductor set to at least 5 mol % and not more than 20 mol %.

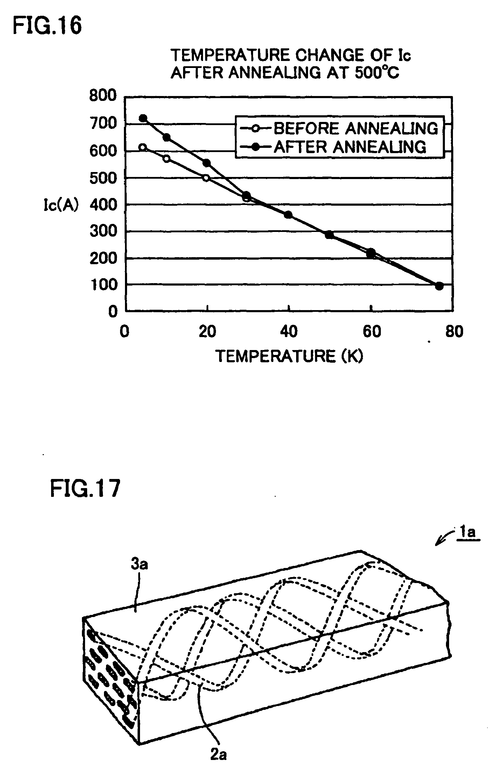

The inventors have also investigated the critical current values $I_c$ of oxide superconducting wires at respective temperatures (K) before performing annealing and after performing the annealing at a temperature of 500°C. Fig. 16 shows the results.

It is understood from the results shown in Fig. 16 that the critical current value $I_c$ of an annealed sample is higher than that of an unannealed sample from a temperature of not more than about 20 K.

In a method of manufacturing an oxide superconducting wire according to this embodiment, the oxide superconducting wire includes a Bi2223 phase, and is annealed in an oxygen-containing atmosphere at a temperature of at least 300°C and not more than 600°C. Thus, the critical current density of the oxide superconducting wire at a low temperature of about 20 K is improved.

This embodiment has been described with reference to a method of improving the critical current density by performing a prescribed heat treatment method in at least either the first heat treatment step (step S4) or the second heat treatment step (step S6) shown in Fig. 2.

(Fifth Example)

Each of the first to fourth examples and embodiments has been described with reference to the manufacturing method in the case where the superconductor filaments 2 extend in the longitudinal direction of the oxide superconducting wire 1 and the oxide superconducting wire 1 is in the form of a tape, as shown in Fig. 1. The oxide superconducting wire shown in Fig. 1 has a high critical current density. However, the manufacturing method according to the present invention is applicable to a method of manufacturing a twisted oxide superconducting wire, for example, in place of the method of manufacturing the oxide superconducting wire shown in Fig. 1.

Fig. 17 is a partially fragmented perspective view conceptually showing the structure of a twisted oxide superconducting wire. As shown in Fig. 17, a twisted oxide superconducting wire 1a has a plurality of oxide superconductor filaments 2a extending in the longitudinal direction and a sheath part 3a covering the same. The oxide superconductor filaments 2a are spirally twisted along the longitudinal direction of the oxide superconducting wire 1a. A method of manufacturing this twisted oxide superconducting wire 1a is now described.

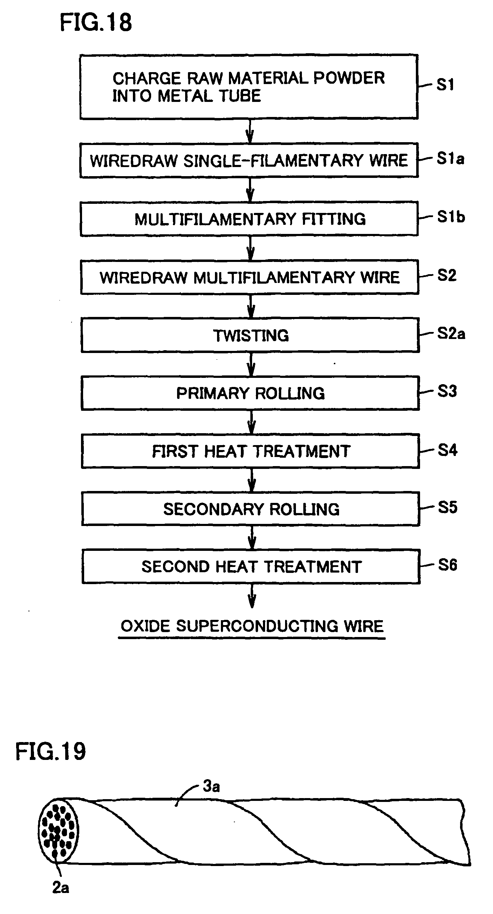

Fig. 18 is a diagram showing manufacturing steps for the twisted oxide superconducting wire. Referring to Fig. 18, a wire is twisted so that twisting pitches are 500 mm, 100 mm, 50 mm and 10 mm respectively, for example, in a state of a round wire (step S2a) after a multifilamentary wire is formed by wiredrawing (step S2) and before primary rolling (step S3) in the method of manufacturing the twisted oxide superconducting wire 1a. Fig. 19 shows the state of this twisting. The remaining manufacturing method is substantially similar to the manufacturing method according to the first example, and hence redundant description is not repeated.

The twisted oxide superconducting wire can effectively reduce AC loss. When the present invention is applied to a method of manufacturing a twisted oxide superconducting wire, the twisted oxide superconducting wire can be inhibited from formation of blisters, and the critical current density can be improved.

The inventors have made a test in order to confirm the aforementioned effect. This test is now described.

Powder having composition ratios of Bi:Pb:Sr:Ca:Cu = 1.82:0.33:1.92:2.01:3.02 was prepared from $Bi_2O_3$, PbO,

$SrCO_3$, $CaCO_3$ and CuO. This powder was heat-treated at a temperature of 750°C for 10 hours, and thereafter heat-treated at a temperature of 800°C for 8 hours. Thereafter a sintered body obtained through the heat treatments was pulverized in an automatic mortar. Powder obtained through the pulverization was heat-treated at a temperature of 850°C for 4 hours, and a sintered body obtained through the heat treatment was pulverized in an automatic mortar. The powder obtained through the pulverization was heat-treated, and thereafter filled into a silver pipe of 36 mm in outer diameter and 30 mm in inner diameter (step S1). Then, the silver pipe filled with the powder was wiredrawn for obtaining a single-filamentary wire (step S1a). Further, 61 such single-filamentary wires were bundled and fitted into a silver pipe of 36 mm in outer diameter and 31 mm in inner diameter (step S1b). Then, the silver pipe fitted with the plurality of single-filamentary wires was wiredrawn for obtaining a multifilamentary wire of 1.5 mm in diameter (step S2). Then, this multifilamentary wire was twisted at twisting pitches of 20 mm, 15 mm, 10 mm and 5 mm (step S2a). Thereafter primary rolling (step S3) was performed for obtaining a tape-shaped wire having a thickness of 0.26 mm, a width of 3.7 mm and a length of 100 m. Then, this wire was heat-treated at a temperature of 840°C in an atmosphere having an oxygen concentration of 8 % for 30 hours as a first heat treatment (step S4). Then, secondary rolling (step S5) was performed for drafting the wire by 8 %. Then, this wire was heat-treated at a temperature of 820°C in an atmosphere having a total pressure of 25 MPa and a partial oxygen pressure of 8 kPa for 50 hours as a second heat treatment (step S6). At a heat-up time before the second heat treatment (step S6), pressurization was started from a temperature reducing the 0.2 % yield strength of the silver pipe below 25 MPa. A sample 1 was prepared from the twisted oxide superconducting wire 1a obtained through the aforementioned steps.

On the other hand, the steps S1 to S5 shown in Fig. 18 were carried out under conditions identical to the above and a wire was heat-treated at a temperature of 820°C in an atmosphere having the atmospheric pressure and a partial oxygen pressure of 8 kPa for 50 hours as a second heat treatment (step S6), for obtaining a twisted oxide superconducting wire of comparative example 1. The critical current densities were measured and the numbers of formed blisters were investigated as to the sample 1 and comparative example 1. Consequently, the critical current density of comparative example 1 was 2.0 kA/cm$^2$, while the critical current density of the sample 1 was 2.6 kA/cm$^2$, which was improved by about 1.3 times. While comparative example 1 caused 30 blisters per 100 m, the sample 1 caused absolutely no blisters. Thus, it is understood that formation of blisters on the twisted oxide superconducting wire can be suppressed and the critical current density can be improved according to the inventive manufacturing method.

The inventive manufacturing method is also applicable to a method of manufacturing a round oxide superconducting wire, for example.

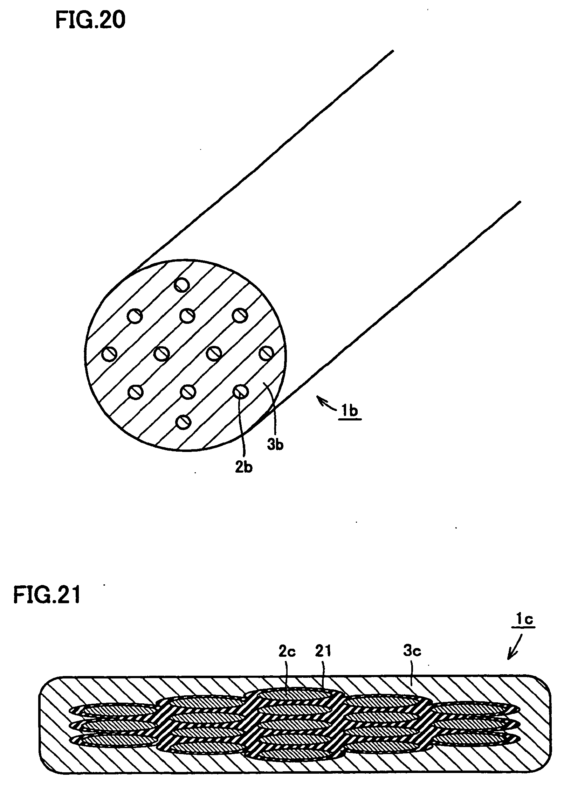

Fig. 20 is a partially fragmented perspective view conceptually showing the structure of a round oxide superconducting wire. As shown in Fig. 20, a round oxide superconducting wire 1b has a plurality of oxide superconductor filaments 2b extending in the longitudinal direction and a sheath part 3b covering the same. The oxide superconducting wire 1b has a sectional shape close to a true circle.

The round oxide superconducting wire 1b is manufactured by not carrying out the primary rolling (step S3) and the secondary rolling (step S5) in the method of manufacturing an oxide superconducting wire shown in Fig. 2. The remaining manufacturing method is substantially similar to the manufacturing method according to the first example, and hence redundant description is not repeated.

The round oxide superconducting wire can effectively reduce AC loss. When the present invention is applied to a method of manufacturing a round oxide superconducting wire, the round oxide superconducting wire can be inhibited from formation of blisters, and the critical current density can be improved.


(Sixth Embodiment)

Each of the first to fourth examples and embodiments has been described with reference to the manufacturing method in the case where the superconductor filaments extend along the longitudinal direction of the oxide superconducting wire and the oxide superconducting wire 1 has a tape-like shape. The fifth example has been described with reference to the manufacturing method in the case where the oxide superconducting wire is a twisted wire or a round wire. In place of these methods of manufacturing oxide superconducting wires, the inventive manufacturing method is also applicable to a method of manufacturing an oxide superconducting wire having a ceramic covering layer, for example.

Fig. 21 is a sectional view conceptually showing the structure of an oxide superconducting wire having a ceramic covering layer. As shown in Fig. 21, an oxide superconducting wire 1c having a ceramic covering layer has a plurality of oxide superconductor filaments 2c extending in the longitudinal direction (direction direction perpendicular to the plane of the figure), a ceramic covering layer 21 covering the plurality of oxide superconductor filaments 2c and a sheath part 3c covering the ceramic covering layer 21. The ceramic covering layer 21 is composed of a metallic oxide, for example, and converted to a non-superconductor at an operation temperature of the oxide superconducting wire 1c. A method of manufacturing the oxide superconducting wire 1c having this ceramic covering layer 21 is now described.

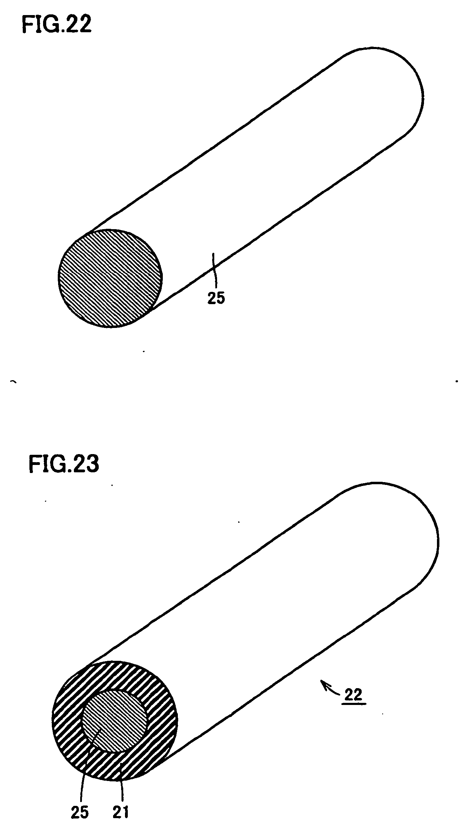

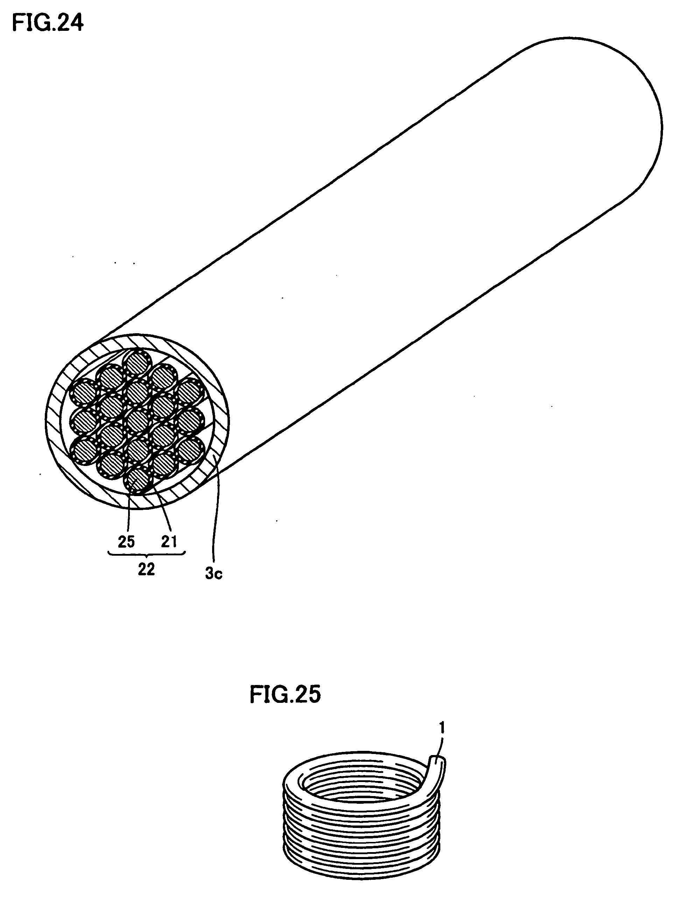

First, raw material powder is molded for forming a rod 25 of the raw material powder, as shown in Fig. 22. Then, the periphery of the rod 25 is covered with compressed ceramic powder through an extruder or the like, for forming a ceramic-covered rod 22 having the ceramic covering layer 22 covering the rod 25 as shown in Fig. 23. Then, a plurality of ceramic-covered rods 22 are fitted in the sheath part 3c, as shown Fig. 24. Thus, a wire of a multifilamentary structure having a large number of filaments of the raw material powder is obtained. Then, the wire of the multifilamentary structure is wiredrawn for forming a multifilamentary wire embedded in the raw material silver sheath part 3c. Thus, a wire formed by covering the ceramic-covered rods, prepared by covering the raw material powder with ceramic, with the metal is obtained. Thereafter the steps S3 to S6 shown in Fig. 2 are carried out for completing the oxide superconducting wire 1c according to this embodiment shown in Fig. 21.

The oxide superconducting wire having a ceramic covering layer can effectively reduce AC loss. When the present invention is applied to a method of manufacturing an oxide superconducting wire having a ceramic covering layer, the oxide superconducting wire having a ceramic covering layer can be inhibited from formation of blisters, and the critical current density can be improved.

In order to confirm the aforementioned effect, the inventors have prepared an oxide superconducting wire having a ceramic covering layer through the manufacturing method according to this embodiment, and measured the critical current density. Consequently, the critical current density was improved to 1.4 times as compared with a case of performing both of two heat treatments in the atmosphere.

(Seventh Example)

When an oxide superconducting wire is applied to a magnet or the like, employed is a substance prepared by winding the oxide superconducting wire in the form of a track reel-shaped coil as shown in Fig. 25. The oxide superconducting wire can be molded into a coil by a wind and react technique.

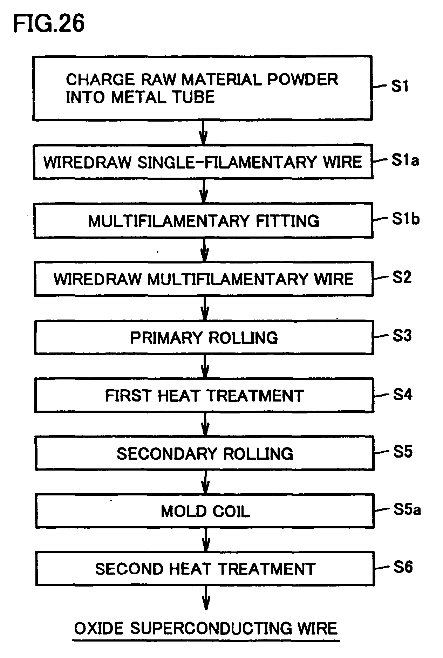

Fig. 26 is a diagram showing manufacturing steps for an oxide superconducting wire according to a seventh example of the present invention. As shown in Fig. 26, the wind and react technique is a method of molding a wire into a coil (step S5a) immediately after secondary rolling (step S5) and thereafter performing a second heat treatment (step S6).

The wire not yet subjected to the second heat treatment (step S6) has stronger flexural strength than the oxide superconducting wire completed through the second heat treatment (step S6). A flexural load is applied to the wire in the step of molding the same into a coil, and hence the coil of the oxide superconducting wire prepared through the wind and react technique is advantageously smaller in deterioration of the critical current value as compared with a coil molded after completion of an oxide superconducting wire. Deterioration of the critical current value can be effectively suppressed by employing the wind and react technique particularly in preparation of a coil of an oxide superconducting wire having a diameter of not more than 100 mm.

On the other hand, the wind and react technique has such a disadvantage that the completed coil of the oxide superconducting wire is unusable if the wire is blistered in the second heat treatment (step S6). Therefore, the wind and react technique is not frequently employed for manufacturing a coil of an oxide superconducting wire in practice.

When the inventive heat treatment method is applied in the second heat treatment (step S6), however, a coil of an oxide superconducting wire can be prepared through the wind and react technique while suppressing blisters of the wire. Thus, deterioration of the critical current value can be effectively suppressed in the case of molding the wire into a coil. The remaining method of manufacturing an oxide superconducting wire is identical to the method of manufacturing an oxide superconducting wire according to the first example shown in Fig. 2, and hence redundant description is not repeated.

(Eighth Example)

The first example has been described with reference to the case of gently increasing the pressure in the atmosphere from the atmospheric pressure according to the state equation of gas before starting the pressurization in the heat treatment (A in Fig. 11), as shown in Fig. 11. However, the inventors have found that the number of blisters formed on the wire can be further reduced by holding the wire under a decompressed atmosphere before starting the pressurization in the heat treatment (A in Fig. 11). The reason for this is now described.

As described with reference to the first example, the gas in the atmosphere penetrates into the wire through pinholes when the pressure in the atmosphere exceeds the pressure in the wire. Therefore, the wire is held under a decompressed atmosphere before the pressurization in the heat treatment is started, so that the pressure in the atmosphere does not exceed the pressure in the wire. Thus, gas hardly penetrates into the wire also in the state before the pressurization in the heat treatment is started, and formation of blisters on the wire can be further suppressed.

The inventors have investigated the effect of holding the wire under a decompressed atmosphere before the pressurization in the heat treatment is started. More specifically, they prepared oxide superconducting wires while setting pressures to about 0.1 MPa (atmospheric pressure) and 10 Pa respectively before starting pressurization in heat treatments. These oxide superconducting wires were dipped in a vessel charged with liquid nitrogen pressurized to 1 MPa, and left for 24 hours. Thereafter the numbers of blisters formed on the respective oxide superconducting wires were examined. Consequently, the oxide superconducting wire prepared by setting the pressure to about 0.1 MPa (atmospheric pressure) before starting the pressurization in the heat treatment caused a blister per 1000 m. On the other hand, the oxide superconducting wire prepared by setting the pressure to about 10 Pa before starting the pressurization in the heat treatment exhibited absolutely no blisters. Thus, it is understood that blisters of the oxide superconducting wire can be further suppressed by holding the wire under a decompressed atmosphere before the pressurization in the heat treatment is started.

This example has been described with reference to the case of holding the wire under a decompressed atmosphere before the pressurization in the heat treatment is started, as a method of manufacturing an oxide superconducting wire.

The embodiments disclosed in the above must be considered illustrative in all points and not restrictive. The range of the present invention is shown not by the aforementioned embodiments but by the scope of claim for patent, and intended to include all corrections and modifications within the meaning and range equivalent to the scope of claim for patent.

## Claims

1.  A method of manufacturing an oxide superconducting wire having

    - a plurality of oxide superconductors (2) extending in the longitudinal direction and
    - a sheath part (3) covering said plurality of oxide superconductors (2),
    - wherein each of said plurality of oxide superconductors (2) has a sintering density of at least 95%,

    said method comprising:

    - a step (S1, S2) of preparing a wire formed by covering raw material powder of an oxide superconductor with a metal including silver and
    - a heat treatment step (S4, S6) of heat-treating said wire in a pressurized atmosphere having a total pressure of at least 1 MPa and less than 50 MPa in the heat treatment, wherein
    - pressurization is started after the temperature of said atmosphere exceeds 400°C at a heat-up time before the heat treatment in said heat treatment step (S4, S6), wherein the speed of said pressurization is at least 0.05 MPa/min.

2.  The method of manufacturing an oxide superconducting wire according to claim 1, wherein said pressurization is started after the temperature of said atmosphere exceeds 600°C at the heat-up time before the heat treatment in said heat treatment step (S4, S6).

3.  The method of manufacturing an oxide superconducting wire according to claim 1, wherein the speed of said pressurization is at least 0.1 MPa/min.

4.  The method of manufacturing an oxide superconducting wire according to claim 1, wherein said heat treatment step (S4, S6) is carried out in an oxygen atmosphere, with a partial oxygen pressure of at least 0.003 MPa and not more than 0.02 MPa.

5.  The method of manufacturing an oxide superconducting wire according to claim 1, wherein

    - said raw material powder of said oxide superconductor includes a Bi2223 phase, and
    - said wire is annealed in an oxygen-containing atmosphere of a temperature of at least 300°C and not more than 600°C in said heat treatment step (S4, S6).

6.  The method of manufacturing an oxide superconducting wire according to claim 1, further comprising a step (S2a) of twisting said wire in advance of said heat treatment step (S4, S6).

7.  The method of manufacturing an oxide superconducting wire according to claim 1, wherein said wire is not rolled.

8.  The method of manufacturing an oxide superconducting wire according to claim 1, wherein a wire formed by covering a ceramic-covered rod (22), obtained by covering said raw material powder (25) with ceramic (21), with said metal (3c) is prepared in said step (S1 to S2) of preparing said wire.

**9.** The method of manufacturing an oxide superconducting wire according to claim 1, further comprising a step (S5a) of molding said wire into a coil in advance of said heat treatment step (S4, S6).

**10.** The method of manufacturing an oxide superconducting wire according to claim 1, wherein said wire is held under a decompressed atmosphere before said pressurization in said heat treatment step (S4, S6) is started.

**Patentansprüche**

**1.** Verfahren zur Herstellung eines supraleitenden Oxiddrahts, der

- mehrere Oxidsupraleiter (2), die sich in Längsrichtung erstrecken, und
- einen Mantelteil (3) aufweist, der die mehreren Oxidsupraleiter (2) ummantelt,
- wobei jeder der mehreren Oxidsupraleiter (2) eine Sinterdichte von mindestens 95% aufweist,

wobei das Verfahren umfasst:

- einen Schritt (S1, S2) des Vorbereitens eines Drahtes, der durch Beschichten von Rohmaterial-Pulver eines Oxidsupraleiters mit einem Metall, das Silber enthält, gebildet wird, und
- einen Wärmebehandlungsschritt (S4, S6) des Wärmebehandelns des Drahtes in einer druckbeaufschlagten Atmosphäre mit einem Gesamtdruck von mindestens 1 MPa und weniger als 50 MPa bei der Wärmebehandlung, wobei
- mit der Druckbeaufschlagung begonnen wird, nachdem die Temperatur der Atmosphäre während einer Aufwärmzeit vor der Wärmebehandlung in dem Wärmebehandlungsschritt (S4, S6) 400°C überschreitet, wobei die Geschwindigkeit der Druckbeaufschlagung mindestens 0,05 MPa/min beträgt.

**2.** Verfahren zur Herstellung eines supraleitenden Oxiddrahts nach Anspruch 1, wobei mit der Druckbeaufschlagung begonnen wird, nachdem die Temperatur der Atmosphäre während einer Aufwärmzeit vor der Wärmebehandlung in dem Wärmebehandlungsschritt (S4, S6) 600°C überschreitet.

**3.** Verfahren zur Herstellung eines supraleitenden Oxiddrahts nach Anspruch 1, wobei die Geschwindigkeit der Druckbeaufschlagung mindestens 0,1 MPa/min beträgt.

**4.** Verfahren zur Herstellung eines supraleitenden Oxiddrahts nach Anspruch 1, wobei der Wärmebehandlungsschritt (S4, S6) in einer Sauerstoffatmosphäre bei einem Sauerstoffpartialdruck von mindestens 0,003 MPa und nicht mehr als 0,02 MPa durchgeführt wird.

**5.** Verfahren zur Herstellung eines supraleitenden Oxiddrahts nach Anspruch 1, wobei

- das Rohmaterial-Pulver des Oxidsupraleiters eine Bi2223-Phase umfasst, und
- der Draht in einer sauerstoffhaltigen Atmosphäre mit einer Temperatur von mindestens 300°C und nicht mehr als 600°C in dem Wärmebehandlungsschritt (S4, S6) ausgeglüht wird.

**6.** Verfahren zur Herstellung eines supraleitenden Oxiddrahts nach Anspruch 1, ferner umfassend einen Schritt (S2a) des Verdrillens des Drahtes vor dem Wärmebehandlungsschritt (S4, S6).

**7.** Verfahren zur Herstellung eines supraleitenden Oxiddrahts nach Anspruch 1, wobei der Draht nicht gewalzt wird.

**8.** Verfahren zur Herstellung eines supraleitenden Oxiddrahts nach Anspruch 1, wobei ein durch Beschichten einer mit Keramik beschichteten Stange (22), die durch Beschichten des Rohmaterial-Pulvers (25) mit Keramik (21) erhalten wird, mit dem Metall (3c) gebildeter Draht in dem Schritt (S1 bis S2) des Vorbereitens des Drahtes vorbereitet wird.

**9.** Verfahren zur Herstellung eines supraleitenden Oxiddrahts nach Anspruch 1, ferner umfassend einen Schritt (S5a) des Formens des Drahtes zu einer Spule vor dem Wärmebehandlungsschritt (S4, S6).

**10.** Verfahren zur Herstellung eines supraleitenden Oxiddrahts nach Anspruch 1, wobei der Draht in einer Unterdruckatmosphäre gehalten wird, bevor die Druckbeaufschlagung im Wärmebehandlungsschritt (S4, S6) beginnt.

**Revendications**

1. Procédé de fabrication d'un fil supraconducteur à base d'oxyde ayant

   - une pluralité de supraconducteurs à base d'oxyde (2) s'étendant dans la direction longitudinale, et
   - ne partie formant gaine (3) recouvrant ladite pluralité de supraconducteurs à base d'oxyde (2),
   - dans lequel chacun de ladite pluralité de supraconducteurs à base d'oxyde (2) a une densité de frittage d'au moins 95 %,

   ledit procédé comprenant :

   - une étape (S1, S2) consistant à préparer un fil formé par le fait de recouvrir d'un métal incluant l'agent une poudre de matière brute d'un supraconducteur à base d'oxyde, et
   - une étape de traitement thermique (S4, S6) consistant à traiter thermiquement ledit fil dans une atmosphère sous pression ayant une pression totale d'au moins 1 MPa et inférieure à 50 MPa dans le traitement thermique, dans lequel
   - la mise sous pression est démarrée après que la température de ladite atmosphère a dépassé 400°C lors d'un temps de montée en température avant traitement thermique dans ladite étape de traitement thermique (S4, S6), la vitesse de ladite mise sous pression étant d'au moins 0,05 MPa/min.

2. Procédé de fabrication d'un fil supraconducteur à base d'oxyde selon la revendication 1, dans lequel ladite mise sous pression est démarrée après que la température de ladite atmosphère a dépassé 600°C lors du temps de montée en température avant traitement thermique dans ladite étape de traitement thermique (S4, S6).

3. Procédé de fabrication d'un fil supraconducteur à base d'oxyde selon la revendication 1, dans lequel la vitesse de ladite mise sous pression est d'au moins 0,1 MPa/min.

4. Procédé de fabrication d'un fil supraconducteur à base d'oxyde selon la revendication 1, dans lequel ladite étape de traitement thermique (S4, S6) est exécutée dans une atmosphère d'oxygène, avec une pression partielle d'oxygène d'au moins 0,003 MPa et non supérieure à 0,02 MPa.

5. Procédé de fabrication d'un fil supraconducteur à base d'oxyde selon la revendication 1, dans lequel

   - ladite poudre de matière brute dudit supraconducteur à base d'oxyde comprend une phase Bi2223, et
   - ledit fil est recuit dans une atmosphère contenant de l'oxygène, d'une température d'au moins 300°C et non supérieure à 600°C dans ladite étape de traitement thermique (S4, S6).

6. Procédé de fabrication d'un fil supraconducteur à base d'oxyde selon la revendication 1, comprenant en outre une étape (S2a) consistant à torsader ledit fil avant ladite étape de traitement thermique (S4, S6).

7. Procédé de fabrication d'un fil supraconducteur à base d'oxyde selon la revendication 1, dans lequel ledit fil n'est pas laminé.

8. Procédé de fabrication d'un fil supraconducteur à base d'oxyde selon la revendication 1, dans lequel un fil formé en recouvrant dudit métal (3c) une tige recouverte de céramique (22), obtenue en recouvrant ladite poudre de matière brute (25) d'une céramique (21), est préparé dans ladite étape (S1 à S2) de préparation dudit fil.

9. Procédé de fabrication d'un fil supraconducteur à base d'oxyde selon la revendication 1, comprenant en outre une étape (S5a) consistant à mouler ledit fil en une bobine avant ladite étape de traitement thermique (S4, S6).

10. Procédé de fabrication d'un fil supraconducteur à base d'oxyde selon la revendication 1, dans lequel ledit fil est maintenu sous une atmosphère hors pression avant que ladite mise sous pression de ladite étape de traitement thermique (S4, S6) soit démarrée.

FIG.1

FIG.2

| CHARGE RAW MATERIAL POWDER INTO METAL TUBE | S1 |

| WIREDRAW SINGLE-FILAMENTARY WIRE | S1a |

| MULTIFILAMENTARY FITTING | S1b |

| WIREDRAW MULTIFILAMENTARY WIRE | S2 |

| PRIMARY ROLLING | S3 |

| FIRST HEAT TREATMENT | S4 |

| SECONDARY ROLLING | S5 |

| SECOND HEAT TREATMENT | S6 |

OXIDE SUPERCONDUCTING WIRE

## FIG.3

## FIG.4

(a)          (b)          (c)          (d)

## FIG.5

NUMBER OF BLISTERS (/10m)

TOTAL PRESSURE P (MPa)

## FIG.6

PRESSURIZED WITH GAS ($N_2$:$O_2$=80:20) OF THE SAME RATIO

OXYGEN PRESSURE (atm.)

$N_2$

$O_2$

TOTAL PRESSURE (atm.)

FIG.7

FIG.8

FIG.9A

FIG.9B

## FIG.10

TEMPERATURE

PRESSURE
IN ATMOSPHERE

PRESSURE
IN WIRE

# FIG.11

Legend:
- TEMPERATURE OF ATMOSPHERE
- TOTAL PRESSURE OF ATMOSPHERE
- PARTIAL OXYGEN PRESSURE OF ATMOSPHERE

TEMPERATURE (°C)

PRESSURE (MPa)
PARTIAL OXYGEN PRESSURE ( × 10⁻³MPa)

TIME (Hr)

A

# FIG.12

PRESSURIZATION STARTING TEMPERATURE
- ■ 600°C
- ▲ 400°C
- ♦ 30°C

SINTERING DENSITY (%)

PRESSING SPEED (MPa/min)

## FIG.13

EP 2 264 718 B1

FIG.14

FIG.15

FIG.16

TEMPERATURE CHANGE OF Ic
AFTER ANNEALING AT 500°C

FIG.17

## FIG.18

```
┌─────────────────────────────────┐
│ CHARGE RAW MATERIAL POWDER      │─ S1
│ INTO METAL TUBE                 │
└─────────────────────────────────┘
              ↓
┌─────────────────────────────────┐
│ WIREDRAW SINGLE-FILAMENTARY WIRE│─ S1a
└─────────────────────────────────┘
              ↓
┌─────────────────────────────────┐
│ MULTIFILAMENTARY FITTING        │─ S1b
└─────────────────────────────────┘
              ↓
┌─────────────────────────────────┐
│ WIREDRAW MULTIFILAMENTARY WIRE  │─ S2
└─────────────────────────────────┘
              ↓
┌─────────────────────────────────┐
│ TWISTING                        │─ S2a
└─────────────────────────────────┘
              ↓
┌─────────────────────────────────┐
│ PRIMARY ROLLING                 │─ S3
└─────────────────────────────────┘
              ↓
┌─────────────────────────────────┐
│ FIRST HEAT TREATMENT            │─ S4
└─────────────────────────────────┘
              ↓
┌─────────────────────────────────┐
│ SECONDARY ROLLING               │─ S5
└─────────────────────────────────┘
              ↓
┌─────────────────────────────────┐
│ SECOND HEAT TREATMENT           │─ S6
└─────────────────────────────────┘
              ↓
    OXIDE SUPERCONDUCTING WIRE
```

## FIG.19

FIG.20

FIG.21

FIG.22

25

FIG.23

22

25  21

## FIG.24

25    21

22    3c

## FIG.25

1

## FIG.26

```
┌─────────────────────────────────┐
│  CHARGE RAW MATERIAL POWDER      │── S1
│  INTO METAL TUBE                 │
└─────────────────────────────────┘
                │
                ▼
┌─────────────────────────────────┐
│  WIREDRAW SINGLE-FILAMENTARY WIRE│── S1a
└─────────────────────────────────┘
                │
                ▼
┌─────────────────────────────────┐
│  MULTIFILAMENTARY FITTING        │── S1b
└─────────────────────────────────┘
                │
                ▼
┌─────────────────────────────────┐
│  WIREDRAW MULTIFILAMENTARY WIRE  │── S2
└─────────────────────────────────┘
                │
                ▼
┌─────────────────────────────────┐
│  PRIMARY ROLLING                 │── S3
└─────────────────────────────────┘
                │
                ▼
┌─────────────────────────────────┐
│  FIRST HEAT TREATMENT            │── S4
└─────────────────────────────────┘
                │
                ▼
┌─────────────────────────────────┐
│  SECONDARY ROLLING               │── S5
└─────────────────────────────────┘
                │
                ▼
┌─────────────────────────────────┐
│  MOLD COIL                       │── S5a
└─────────────────────────────────┘
                │
                ▼
┌─────────────────────────────────┐
│  SECOND HEAT TREATMENT           │── S6
└─────────────────────────────────┘
                │
                ▼
    OXIDE SUPERCONDUCTING WIRE
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5101723 A
- JP 2592846 B
- JP 1030114 A
- WO 0122436 A
- US 6069116 A